# EUROPÄISCHE PATENTANMELDUNG

(11) **EP 2 224 795 A1**
(43) Veröffentlichungstag der Anmeldung: **01.09.2010**
(21) Anmeldenummer: 09010991.9
(22) Anmeldetag: 27.08.2009
(51) Int. Cl.: H05K 3/20, H01L 51/00

(54) **Verfahren zur Herstellung einer Metallstruktur auf einem Substrat**

(30) Priorität: 26.02.2009 DE 102009010434
(71) Anmelder: ZYRUS Beteiligungsgesellschaft mbH & Co. Patente I KG, 12529 Schönefeld / OT Waltersdorf (DE)
(72) Erfinder: Rostami, Bardia, Dr., 22299 Hamburg (DE); Kruse, Jan, Dr., 22089 Hamburg (DE); Uelzen, Thorsten, Dr., 21698 Bargstedt (DE); Becker, Eike, 38102 Braunschweig (DE)
(74) Vertreter: Kloth, Matthias

(57) **Zusammenfassung**

Erfindungsgemäß ist ein Verfahren zur Herstellung einer Metallstruktur auf einem Substrat, gekennzeichnet durch die Verfahrensschritte:
a. einen Polymerisationsprozess, wobei mindestens eine Strukturelektrode verwendet wird, deren Oberfläche einen ersten Bereich einer vorgebbaren Struktur (Elektrodenkontaktbereich) und einen übrigen, zweiten Bereich (Elektrodenkomplementärbereich) aufweist, wobei der Elektrodenkontaktbereich mit einem ersten Spannungspotential verbindbar ist, wenigstens ein Teil des Elektrodenkontaktbereiches in Kontakt mit einem, vorzugsweise flüssigen, ersten Elektrolyten gebracht wird, wobei in den ersten Elektrolyten polymerisier- und/oder vernetzbare Verbindungen eingebracht sind, und über die Strukturelektrode ein erster Stromfluss durch den ersten Elektrolyten erzeugt wird, wobei auf den mit dem ersten Elektrolyten in Kontakt gebrachten Elektrodenkontaktbereich ein leitfähiger Polymerfilm der vorgegebenen Struktur gebildet wird (Polymerstruktur),
b. einen Galvanikprozess, wobei wenigstens ein Teil der Polymerstruktur in Kontakt mit einem, vorzugsweise flüssigen, zweiten Elektrolyten gebracht wird, wobei in den zweiten Elektrolyten ein metallischer Stoff eingebracht ist, wobei über die Polymerstruktur ein zweiter Stromfluss durch den zweiten Elektrolyten erzeugt wird, wobei auf den mit dem zweiten Elektrolyten in Kontakt gebrachten Bereich der Polymerstruktur ein leitfähiger Metallfilm der vorgegebenen Struktur gebildet und/oder abgeschieden wird (Metallstruktur),
c. einen Transfer der Metallstruktur auf das Substrat, wobei wenigstens ein Teil der Metallstruktur auf das Substrat aufgebracht wird, und/oder einen Transfer der Polymerstruktur auf das Substrat, wobei wenigstens ein Teil der Polymerstruktur auf das Substrat aufgebracht wird.

## Beschreibung

Die Erfindung betrifft ein Verfahren zur Herstellung einer Metallstruktur auf einem Substrat.

### Stand der Technik

Für die Erzeugung elektrisch leitfähiger Strukturen auf Leiterplatten ist aus dem Stand der Technik eine Vielzahl unterschiedlicher technischer Verfahren bekannt. Die bekannten Verfahren unterscheiden sich, neben dem jeweils erforderlichen apparativen Aufwand, hauptsächlich durch die mit ihnen erzielbare Auflösung, Oberflächengüte und die Verfahrensgeschwindigkeit. Die Leiterbahnen zur elektrischen Verbindung der elektronischen Bauteile werden üblicherweise durch Masken-Ätzen, geeignete Druckverfahren oder Laserbearbeitung auf den Leiterplatten erstellt. Grundsätzlich können Leiterplatten jegliche Art von, insbesondere flexiblen, Leiterplatten, Folien, Keramiken oder dergleichen sein.

In diesem Zusammenhang sind aus dem Stand der Technik gedruckte Elektroniken bekannt, bei denen die elektronischen Bauelemente, Baugruppen und Anwendungen aber vor allem de Leiterbahnen vollständig oder teilweise mittels geeigneter Druckverfahren auf den Leiterplatten appliziert werden. In diesem Fall werden an Stelle von Druckfarben elektronische Funktionsmaterialien, die in flüssiger oder pastöser Form vorliegen, verdruckt.

Von den zum Einsatz kommenden Laserbehandlungsverfahren zur Erzeugung von Leiterbahnen auf Leiterplatten sind vor allem das Laser-Direct-Imaging (LDI) sowie das Laser-Direct-Patterning (LDP) zu nennen. Beim Laser-Direct-Imaging wird zunächst eine Metallisierung, in der Regel in flächiger Form, auf eine Leiterplatte aufgebracht. Darauf kommt ein fotoempfindlicher Lack, der dann durch den Laser direkt schreibend oder per Maske belichtet wird. Anschließend wird das Metall dann geätzt und der Lack entfernt.

Im Gegensatz hierzu wird beim Laser-Direct-Patterning eine Substratfläche mit einem aufgeweiteten Laserpuls über eine Maske direkt strukturiert. Diese Methode hat vor allem den Vorteil, dass Sie schneller als das Laser-Direct-Imaging arbeitet; sie erfordert jedoch sehr dünne Metallschichten.

Den aus dem Stand der Technik bekannten Fertigungsverfahren zur Erzeugung von Leiterbahnen auf Leiterplatten ist gemein, dass ihre Auflösung für eine Vielzahl von Anwendungen in dem Elektronikbereich nicht mehr ausreichend ist und zukünftig zunehmend nicht mehr sein wird.

Weiterhin sind aus dem Stand der Technik Verfahren zur Herstellung einer Metallstruktur auf einem Substrat bekannt, die sich dadurch auszeichnen, dass auf einem Substrat zunächst ein dünner Metallfilm großflächig aufgebracht wird. Auf diesen Metallfilm wird eine Fotoschicht aufgebracht, die komplementär zu der gewünschten Struktur fotochemisch oder per Lasertechnik entfernt wird. Die in diesem komplementären Bereich freigelegte Metallstruktur wird daraufhin weggeätzt. Abschließend wird der noch mit der Metallstruktur in Verbindung stehende Fotolack, beispielsweise durch ein Lösen mittels eines Lösungsmittels, entfernt.

Ein weiteres Verfahren aus dem Stand der Technik kennzeichnet sich im Wesentlichen durch einen Druckprozessschritt und einen Galvanikprozessschritt. Nach diesem Verfahren wird zunächst auf das Substrat ein sogenanntes Seedlayer aufgedruckt. Der Druck wird dazu in der Weise ausgeführt, dass das Seedlayer die gewünschte Struktur aufweist. Als Druckmittel eignet sich dazu ein in einem Lösungsmittel gelöstes leitfähiges Polymer. Nach dem Druck wird das Lösungsmittel in den gasförmigen Aggregatzustand überführt, sodass das leitfähige Polymer auf dem Substrat haftet. Das Seedlayer wird danach in Kontakt mit einem flüssigen Elektrolyten gebracht. In den Elektrolyten ist das abzuscheidende Material eingebracht, wobei die Abscheidung mittels eines galvanischen Prozesses erfolgt. Für die Galvanik notwendig sind eine Elektrode und eine Gegenelektrode. Die Elektrode wird durch das Seedlayer auf dem Substrat gebildet. Es ist deshalb bei dem Entwurf des Seedlayers darauf zu achten, dass jedes auch noch so kleine Teilelement des Seedlayers eine laterale Leitungsverbindung zu einer Kante des Substrates aufweist, an der eine elektrische Kontaktierung erfolgen kann. Denn die galvanische Abscheidung des Metalls auf dem Seedlayer kann nur dann vollständig erfolgen, wenn jede Teilfläche des Seedlayers mit einem ersten elektrischen Potential verbunden ist, und die Gegenelektrode mit einem davon abweichenden anderen elektrischen Potential verbunden ist. In den meisten praktischen Fällen weist die gewünschte Struktur jedoch nicht die zuvor genannten lateralen Verbindungen zu einer Kante auf. Der Seedlayer weist deshalb häufig zusätzliche Teilflächen auf, die diese Verbindungen herstellen. Für die spätere Anwendung sind diese Verbindungen ungewünscht. Die zusätzliche Abscheidung des Metalls auf dem Substrat wird in einem nachträglichen Nachbearbeitungsschritt rückgängig gemacht.

Den zuvor erläuterten Verfahren gemeinsam ist, dass die maximale Auflösung der Metallstruktur gering ist.

### Aufgabe

Der Erfindung liegt die Aufgabe zugrunde, ein Verfahren bereitzustellen, durch das mit möglichst geringem Aufwand Metallstrukturen mit einer hohen Auflösung auf einem Substrat herstellbar sind.

Es ist vorteilhaft, wenn mit dem Verfahren auch die Herstellung von Metallstrukturen in einem kontinuierlichen Prozess ermöglicht wird.

Ferner ist es von Vorteil, wenn die Herstellung von Metallstrukturen mit einer hohen Auflösung, insbesondere im Bereich von 5 Mikrometern, möglich ist.

### Lösungsvorschlag

Die Aufgabe der Erfindung wird erfindungsgemäß durch ein Verfahren mit den Merkmalen des Anspruches 1 gelöst. Durch die Erfindung ist es möglich, kostengünstig eine hochauflösende Metallstruktur auf einem Substrat herzustellen. Dazu wird zunächst ein Polymerisationsprozess durchgeführt, wobei mindestens eine Strukturelektrode verwendet wird, deren Oberfläche einen ersten Bereich einer vorgebbaren Struktur (Elektrodenkontaktbereich) und einen übrigen, zweiten Bereich (Elektrodenkomplementärbereich) aufweist, wobei der Elektrodenkontaktbereich mit einem ersten Spannungspotential verbindbar ist, wenigstens ein Teil des Elektrodenkontaktbereiches in Kontakt mit einem, vorzugsweise flüssigen, ersten Elektrolyten gebracht wird, wobei in den ersten Elektrolyten polymerisier- und/oder vernetzbare Verbindungen eingebracht sind, und über die Strukturelektrode ein erster Stromfluss durch den ersten Elektrolyten erzeugt wird, wobei auf dem mit dem ersten Elektrolyten in Kontakt gebrachten Elektrodenkontaktbereich ein leitfähiger Film aus den polymerisier- oder vernetzbaren Verbindungen der vorgegebenen Struktur gebildet wird (Polymerstruktur). Im Anschluss kann die Strukturelektrode aus dem ersten Elektrolyten entnommen und wenigstens ein Teil des mit dem leitfähigen Film beschichteten Elektrodenkontaktbereich mit einem zweiten, vorzugsweise flüssigen Elektrolyten in Kontakt gebracht werden, wobei in den zweiten Elektrolyten Metallionen eingebracht sind, und über die Strukturelektrode ein Stromfluss durch den zweiten Elektrolyten erzeugt wird, wobei auf dem mit dem zweiten Elektrolyten in Kontakt gebrachten und auf dem Elektrodenkontaktbereich befindlichen leitfähigen Film eine Metallstruktur gebildet und/oder abgeschieden wird.

Ziel des Verfahrens ist die Herstellung einer Metallstruktur auf einem Substrat. Das Substrat kann dazu ein Basismaterial oder auch die oberste Schicht eines Basismaterials sein. Bevorzugt ist das Substrat ein Kunststoff. Auch kann es bevorzugt sein, dass das Substrat, insbesondere elektrisch, isolierend ausgestaltet ist. Das Substrat kann eine beliebige Oberflächenform aufweisen. Bevorzugt ist es jedoch, dass die Oberfläche des Substrats zumindest im Wesentlichen eben ist. In einer bevorzugten Ausgestaltung kann das Substrat eine Leiterplatte und/oder ein Basismaterial oder Basiselement einer Leiterplatte sein.

Erfindungsgemäß ist auch die nach dem Verfahren hergestellte Metallstruktur auf dem Substrat. Dies kann bedeuten, dass die Metallstruktur zumindest im Wesentlichen nur auf dem Substrat ist. Es ist aber auch möglich, dass die Metallstruktur und das Substrat eine form-, kraft- und/oder stoffschlüssige Verbindung aufweisen. Grundsätzlich kann die Form der Metallstruktur beliebig ausgestaltet sein. Sie kann einen beliebigen Teil der Oberfläche des Substrates ab$-und/oder bedecken. Insbesondere wenn das Substrat eine Leiterplatte ist, kann die Metallstruktur einen Teil, Teile oder die gesamte Funktionsoberfläche eines Substrates be- und/oder abdecken. Eine Funktionsoberfläche eines Substrates kann diejenige Oberfläche sein, für die es vorgesehen ist, dass sie mit anderen Funktionsstoffen, Funktionsmaterialien und/oder anderen Vorrichtungen zusammenwirken kann. Dieses Zusammenwirken kann insbesondere ein Halten sein.

Es ist besonders bevorzugt, dass die Metallstruktur eine bestimmte Struktur, insbesondere die vorgebbare Struktur, aufweist. Die vorgebbare Struktur kann also eine Oberflächenstruktur sein.

Elektronische Bauelemente werden bevorzugt durch elektronische Leitungsverbindungen miteinander verbunden. Durch die Metallstruktur auf dem Substrat können elektrische Bauteile miteinander verbunden sein. Dabei kann die Metallstruktur die elektrischen Leitungsverbindungen zwischen den Bauteilen, insbesondere auf dem Substrat, sein. Grundsätzlich ist es nicht bevorzugt, dass alle Anschlüsse aller Bauteile einer elektrischen Schaltung elektrisch, elektrisch "sternförmig", miteinander verbunden sind. Vielmehr zeichnet sich eine elektrische Schaltung oftmals dadurch aus, dass sie eine gewisse Struktur aufweist. Eine elektrische Schaltung ist in diesem Sinne vielfach in der Weise ausgestaltet, dass elektrische Leitungsverbindungen nur zwischen bestimmten, ausgewählten Anschlüssen, insbesondere von elektrischen Bauteilen, ausgebildet sind.

Einer der bevorzugt wesentlichen Schritte des Verfahrens ist der Polymerisationsprozess. Für den Polymerisationsprozess wird mindestens eine Strukturelektrode verwendet, deren Oberfläche einen ersten Bereich einer vorgebbaren Struktur (Elektrodenkontaktbereich) und einen übrigen, zweiten Bereich (Elektrodenkomplementärbereich) aufweist. Bereits zuvor wurde eingeführt, dass es eine vorgebbare Struktur gibt. Diese vorgebbare Struktur kann beispielsweise die Struktur einer elektrischen Schaltung und/oder die Oberflächenausgestaltung bzw. Oberflächenstruktur der elektrischen (Verbindungs-)Leitungen einer Schaltung sein. Um es zu ermöglichen, dass die Metallstruktur auf dem Substrat auch die vorgebbare Struktur aufweist, ist es von Vorteil, wenn zumindest ein Teil der Oberfläche der Strukturelektrode eine zu der vorgebbaren Struktur entsprechende Struktur aufweist. In diesem Sinne weist die Strukturelektrode einen Elektrodenkontaktbereich auf. Dieser Elektrodenkontaktbereich kann eine zusammenhängende Fläche der Oberfläche der Strukturelektrode sein. Für praktische Anwendungen ist dieses jedoch nur selten bevorzugt. Eine Ausgestaltung des Elektrodenkontaktbereiches zeichnet sich dadurch aus, dass diese aus mehreren, nicht zusammenhängenden Oberflächenbereichen der Strukturelektrode besteht. Diese nicht zusammenhängenden Bereiche können der erste Bereich der Strukturelektrode sein. Der Elektrodenkomplementärbereich kann der übrige, zweite Bereich der Oberfläche der Strukturelektrode sein. Der Elektrodenkomplementärbereich kann ein zusammenhängender Teilbereich der Oberfläche der Strukturelektrode sein. Der Elektrodenkomplementärbereich kann aber auch aus mehreren Teilbereichen der Oberfläche der Strukturelektrode bestehen. Es ist deshalb auch möglich, dass der Elektrodenkontaktbereich und der Elektrodenkomplementärbereich keinen Überlappungsbereich und/oder keine Schnittmenge aufweisen. Mit der Oberfläche der Strukturelektrode kann eine Funktionsoberfläche der Strukturelektrode gemeint sein. Die Funktionsoberfläche einer Strukturelektrode kann diejenige Oberfläche sein, die dafür bestimmt ist, mit einem Elektrolyten in Kontakt gebracht werden zu können. Von der Oberfläche der Strukturelektrode kann bevorzugt der Anschlussbereich der Strukturelektrode ausgenommen sein. Die Strukturelektrode kann grundsätzlich die Eigenschaften einer aus dem Stand der Technik bekannten Elektrode aufweisen. Sie wird hier jedoch Strukturelektrode genannt, weil sie zumindest zwei Bereiche aufweist.

Es ist ferner erfindungsgemäß, dass der Elektrodenkontaktbereich mit einem ersten Spannungspotenzial verbindbar ist. Der Elektrodenkontaktbereich kann dazu durch mindestens eine elektrische Leitung mit dem ersten Spannungspotenzial verbindbar sein. Insbesondere für einfache Anwendungen kann es bevorzugt sein, dass der Elektrodenkontaktbereich oder seine Teilbereiche, insbesondere in der Strukturelektrode, elektrisch miteinander verbunden ist. Dieser verbundene Elektrodenkontaktbereich kann, insbesondere durch eine elektrisch leitende Leitung, mit dem ersten Spannungspotenzial verbunden sein. Eine Spannungsquelle weist für gewöhnlich mindestens zwei Spannungspotenziale auf, die sich in ihrer Spannungshöhe voneinander unterscheiden. Um diese Spannungspotenziale für Vorrichtungen zugänglich zu machen, weisen Spannungsquellen für gewöhnlich Spannungsanschlüsse auf. Somit kann auch der Elektrodenkontaktbereich durch eine elektrische Leitungsverbindung mit dem Anschluss eines ersten Spannungspotenzials einer Spannungsquelle verbindbar sein. Der Elektrodenkontaktbereich der Strukturelektrode ist deshalb bevorzugt elektrisch leitend. Der Elektrodenkomplementärbereich kann hingegen elektrisch isolierend sein.

Für den Polymerisationsprozess wird wenigstens ein Teil des Elektrodenkontaktbereiches in Kontakt mit einem, vorzugsweise flüssigen, ersten Elektrolyten gebracht. Dazu kann die Strukturelektrode zumindest teilweise in den ersten Elektrolyten eingetaucht werden. Hierbei ist es nicht zwingend notwendig, dass die gesamte Strukturelektrode in den ersten Elektrolyten eingetaucht wird. Vielmehr ist es möglich, dass nur ein Teil der Strukturelektrode mit dem ersten Elektrolyten in Kontakt gebracht wird. Dazu kann die Strukturelektrode nur teilweise, beispielsweise zur Hälfte, in den ersten Elektrolyten eingetaucht werden. Es ist jedoch bevorzugt, dass die gesamte Oberfläche und/oder Funktionsoberfläche der Strukturelektrode mit dem ersten Elektrolyten in Kontakt gebracht wird. Grundsätzlich kann der erste Elektrolyt einen beliebigen Aggregatzustand aufweisen. Der erste Elektrolyt kann also fest, flüssig oder gasförmig sein. Der Elektrolyt kann ein, bevorzugt organische Stoffe lösendes, Lösungsmittel aufweisen. Es wird bevorzugt, dass der erste Elektrolyt flüssig ist. Ein bevorzugtes Lösungsmittel kann Methanol, Ethanol, Aceton, Isopropanol, NMP, Dichlormethan und/oder Wasser sein. Auch kann eine Mischung aus zwei oder mehr Lösungsmitteln möglich sein, so beispielsweise mit Wasser, Acetonitril, Propylencarbonat und/oder Dichlormethan. Besonders bevorzugt ist der Elektrolyt eine elektrisch leitende Lösung, insbesondere mit Kationen und Anionen. Außerdem sind in den ersten Elektrolyten polymerisier- und oder vernetzbare Verbindungen eingebracht. Polymerisierbare Verbindungen können vorzugsweise Monomere sein. Grundsätzlich können polymerisierbare Verbindungen auch niedermolekulare und/oder reaktionsfähige Moleküle sein, die zu Polymeren, beispielsweise zu unverzweigten und/oder verzweigten Polymeren, verbindbar sind. Eine polymerisierbare Verbindung weist vorzugsweise eine reaktionsfähige Doppelbindung und/oder insbesondere eine ungesättigte organische Verbindung auf. Unter vernetzbaren Verbindungen können Moleküle, insbesondere Makromoleküle, verstanden werden, die zu einem dreidimensionalen Netzwerk verknüpfbar sind. Die vernetzbaren Verbindungen können in der Weise ausgewählt sein, dass sie eine Polymerisation begünstigen und/oder auslösen.

Eine vorteilhafte Ausgestaltung des Verfahrens zeichnet sich dadurch aus, dass der erste Elektrolyt ein, vorzugsweise organisches, Lösungsmittel und/oder ein in einem Lösungsmittel gelöstes Salz aufweist, wobei der erste Elektrolyt so ausgewählt sein kann, dass die polymerisier- und/oder vernetzbaren, insbesondere niedermolekularen, Verbindungen in ihm lösbar sind. Als Lösungsmittel können Propylencarbonat, Acetonitril, ein- oder mehrwertige Alkohole, Tetrahydrofuran oder Wasser, jeweils einzeln oder in beliebiger Mischung, verwendet werden. Als Salze können beispielsweise Tetraethylammonium-Tetrafluoroborat, Tetraethylammonium-Hexafluorophosphat, Tetraethylammonium-Perchlorat oder Poly(styrolsulfonsäure)-Natriumsalz, jeweils einzeln oder in beliebiger Kombination, verwendet werden.

Eine weitere vorteilhafte Ausgestaltung des Verfahrens zeichnet sich dadurch aus, dass als in den ersten Elektrolyten eingebrachte Verbindungen Pyrrole, 3-Alkylpyrrole, insbesondere 3-Methyl-, 3-Ethyl-, 3-Propylpyrrole, *N-*Alkylpyrrole, insbesondere *N-*Methyl-, *N-*Ethyl-, *N-*Propylpyrrole, *N-*Arylpyrrole, insbesondere *N-*Phenyl-, *N-*(4-Amino)phenyl-, *N-*(4-Methoxy)phenyl-, *N-*Naphtylpyrrole, *N-*Heteroarylpyrrole, insbesondere *N-*(3-Thienyl)-, *N-*(2-Thienyl)-, *N*-(3-Furanyl)-, *N-*(2-Furanyl)-, *N-*(3-Selenophenyl)-, *N-*(2-Selenophenyl)-, *N-*(3-Pyrrolyl)pyrrole, Thiophene, 3-Alkylthiophene, insbesondere 3-Methyl-, 3-Ethyl-, 3-Propylthiophene, Furane, 3-Alkylfurane, 3-Methyl-, 3-Ethyl-, 3-Propylfurane, Selenophene, 3-Alkylselenophene, insbesondere 3-Methyl-, 3-Ethyl-, 3-Propylselenophene, Tellurophene, Aniline, Biphenyle, Azulene, 2-(alpha-Thienyl)thiophene, 2-(alpha-(3-Alkyl)thienyl)thiophene, 2-(alpha-(3-Alkyl)thienyl)-(3-alkyl)thiophene, 2-(alpha-Thienyl)furane, 2-(alpha-(3-Alkyl)thienyl)furane, 2-(alpha-(3-Alkyl)thienyl)-(3-alkyl)furane, 2-(alpha-Thienyl)-(3-alkyl)furane, 2-(alpha-Thienyl)pyrrole, 2-(alpha-(3-Alkyl)thienyl)pyrrole, 2-(alpha-(3-Alkyl)thienyl)-(3-alkyl)pyrrole, 2-(alpha-Thienyl)-(3-alkyl)pyrrole, 2-(alpha-Furanyl)pyrrole, 2-(alpha-(3-Alkyl)furanyl)pyrrole, 2-(alpha-(3-Alkyl)furanyl)-(3-alkyl)pyrrole, 2-(alpha-Furanyl)-(3-alkyl)pyrrole, 2-(alpha-Pyrrolyl)pyrrole, 2-(alpha-(3-Alkyl)pyrrolyl)pyrrole, 2-(alpha-(3-Alkyl)pyrrolyl)-(3-alkyl)pyrrole, 2-(alpha-pyrrolyl)-(3-alkyl)pyrrole, 2-(alpha-Selenophenyl)selenophene, 2-(alpha-(3-Alkyl)selenophenyl)selenophene, 2-(alpha-(3-Alkyl)selenophenyl)-(3-alkyl)selenophene, 2-(alpha-Thienyl)selenophene, 2-(alpha-(3-Alkyl)thienyl)selenophene, 2-(alpha-(3-Alkyl)thienyl)-(3-alkyl)selenophene, 2-(alpha-Thienyl)-(3-alkyl)selenophene, 2-(alpha-Selenophenyl)furane, 2-(alpha-(3-Alkyl)selenophenyl)furane, 2-(alpha-(3-Alkyl)selenophenyl)-(3-alkyl)furane, 2-(alpha-Selenophenyl)-(3-alkyl)furane, 2-(alpha-Selenophenyl)pyrrole, 2-(alpha-(3-Alkyl)selenophenyl)pyrrole, 2-(alpha-(3-Alkyl)selenophenyl)-(3-alkyl)pyrrole, 2-(alpha-Selenophenyl)-(3-alkyl)pyrrole, Thienothiophene, Thienofurane, Thienoselenophene, Thienopyrrole, 2-Phenylthiophene, 2-Phenylfurane, 2-Phenylpyrrole, 2-Phenylselenophene, 2-Phenyltellurophene, *N-*Vinylcarbazol, *N*-Ethynylcarbazol, 3,4-Ethylendioxythiophene, 2-(alpha-(3,4-Ethylendioxy)thienyl)thiophene, 2-(alpha-(3,4-Ethylendioxy)thienyl)-3,4-Ethylendioxythiophene, 2-(alpha-(3,4-Ethylendioxy)thienyl)-(3-alkyl)thiophene, 2-(alpha-(3,4-Ethylendioxy)thienyl)furane, 2-(alpha-(3,4-Ethylendioxy)thienyl)-(3-alkyl)furane, 2-(alpha-(3,4-Ethylendioxy)thienyl)pyrrole, 2-(alpha-(3,4-Ethylendioxy)thienyl)-(3-alkyl)pyrrole, 2-(alpha-(3,4-Ethylendioxy)thienyl)selenophene oder 2-(alpha-(3,4-Ethylendioxy)thienyl)-(3-alkyl)selenophene jeweils einzeln oder in beliebiger Kombination oder als oligomere Monomereinheiten verwendet werden.

Der Elektrolyt kann ein elektrischer Leiter zweiter Klasse oder lonenleiter sein. In diesem Sinne kann die Leitfähigkeit des Elektrolyten durch eine Dissoziation oder Aufspaltung mindestens einer der Bindungen der Moleküle entstehen. Auf diese Weise können elektrisch geladene Ionen in dem Elektrolyten entstehen. Die Leitfähigkeit des Elektrolyten kann auf die elektrisch geladenen, vorzugsweise frei beweglichen, Ionen zurückzuführen sein. Der Elektrolyt kann deshalb auch ein Stoff sein, der unter Einfluss eines elektrischen Feldes, vorzugsweise zwischen zwei unterschiedlichen hohen Spannungsniveaus, die Bewegung von elektrischen Ladungsträgern ermöglicht. Der Elektrolyt kann also ein Stoff sein, durch den ein Strom leitbar ist.

Die Strukturelektrode und/oder der Elektrodenkontaktbereich ist mit einem ersten Spannungspotenzial verbindbar. Für eine bevorzugte Ausgestaltung wird eine Gegenelektrode in Kontakt mit dem Elektrolyten gebracht. Die Gegenelektrode kann dazu nicht die Strukturelektrode sein. Die Gegenelektrode kann dazu insbesondere eine separate Elektrode sein. Die Gegenelektrode kann ferner mit einem zweiten, vorzugsweise von dem ersten Spannungspotenzial abweichenden, Spannungspotenzial verbindbar sein. Zwischen dem ersten Spannungspotenzial und dem zweiten Spannungspotenzial kann deshalb ein Potenzialunterschied sein. Für eine vorteilhafte Ausgestaltung der Erfindung kann der Elektrodenkomplementärbereich mit dem zweiten Spannungspotenzial verbindbar sein. In diesem Sinne können das erste Spannungspotenzial und das zweite Spannungspotenzial mit der Strukturelektrode verbindbar sein. Der Elektrodenkomplementärbereich der Strukturelektrode kann elektrisch leitend ausgestaltet sein. Der Elektrodenkontaktbereich kann elektrisch isolierend von dem Elektrodenkomplementärbereich ausgestaltet sein. Dazu kann die Strukturelektrode zwischen dem Elektrodenkontaktbereich und dem Elektrodenkomplementärbereich einen elektrisch isolierenden Stoff aufweisen.

Vor, während und/oder nach dem in Kontakt bringen des wenigstens einen Teils des Elektrodenkontaktbereiches mit dem ersten Elektrolyten kann der Elektrodenkontaktbereich mit dem ersten Spannungspotenzial und/oder die Gegenelektrode mit dem zweiten Spannungspotenzial und/oder der Elektrodenkomplementärbereich mit dem zweiten Spannungspotenzial verbunden sein. Der Polymerisationsprozess zeichnet sich auch dadurch aus, dass über die Strukturelektrode ein erster Stromfluss durch den ersten Elektrolyten erzeugt wird. Dazu kann in dem ersten Elektrolyten ein elektrisches Feld ausgebildet sein. Dieses Feld kann durch einen elektrischen Potenzialunterschied verursacht sein. Insbesondere kann der erste Stromfluss durch ein elektrisches Feld verursacht worden sein, dass sich zwischen dem ersten Spannungspotenzial und bevorzugt dem zweiten Spannungspotenzial ausbildet. Elektrische Ladungsträger können also durch den ersten Elektrolyten und durch den Elektrodenkontaktbereich der Strukturelektrode geleitet werden. Durch den Elektrodenkontaktbereich und/oder den Elektrolyten kann also ein erster Stromfluss entstehen. Mit anderen Worten kann ein Strom durch den ersten Elektrolyten und den Elektrodenkontaktbereich der Strukturelektrode (und in diesem Sinne auch über die Strukturelektrode) fließen.

Es ist erfindungsgemäß, dass auf dem mit dem ersten Elektrolyten in Kontakt gebrachten Elektrodenkontaktbereich ein leitfähiger Polymerfilm der vorgegebenen Struktur gebildet wird (Polymerstruktur). Die Bildung des Polymerfilms und/oder der Polymerstruktur erfolgt bevorzugt durch eine Polymerisation der in den ersten Elektrolyten eingebrachten polymerisier- und/oder vernetzbaren Verbindungen. Unter einer Polymerisation kann eine chemische Reaktion verstanden werden, bei der Verbindungen zu einem Makromolekül vereinigt werden. Diese Verbindungen können die polymerisier- und/oder vernetzbaren Verbindungen sein, die in den ersten Elektrolyten eingebracht sind. Ein polymerisiertes Makromolekül kann die im Wesentlichen gleiche chemische Zusammensetzung aufweisen, wie die Verbindungen, aus denen es synthetisiert und/oder hergestellt wurde. Das Makromolekül kann dann jedoch eine andere Molekülstruktur aufweisen. Für die Polymerisation kann es vorteilhaft sein, wenn die polymerisier- und/oder vernetzbaren Verbindungen Doppelbindungen aufweisen. Denn diese Doppelbindungen können durch Energiezufuhr "aufgeklappt" werden. Diese Energiezufuhr kann an die polymerisier- und/oder vernetzbaren Verbindungen durch den ersten Stromfluss erfolgen. Diejenigen Verbindungen der polymerisier-und/oder vernetzbaren Verbindungen, die durch die Energiezufuhr bzw. durch den Stromfluss eine derart "aufgeklappte" Doppelbindung aufweisen, können sich zu Molekülketten und/oder Makromolekülen zusammenschließen. Auf diese Weise kann ein Polymerfilm und insbesondere ein leitfähiger Polymerfilm gebildet werden. Es ist bevorzugt, dass der Stromfluss über den Elektrodenkontaktbereich durch den Elektrolyten erfolgt. Deshalb polymerisieren die polymerisier- und/oder vernetzbaren Verbindungen aus dem ersten Elektrolyten auch vorzugsweise an dem Elektrodenkontaktbereich und/oder in dessen unmittelbarer Nähe. Mit anderen Worten: Da der erste Elektrolyt zumindest teilweise in Kontakt mit dem Elektrodenkontaktbereich gebracht wird und die Polymerisation der polymerisier- und/oder vernetzbaren Verbindungen somit bevorzugt an dem Elektrodenkontaktbereich stattfinden, scheidet sich ein Polymerfilm, im Wesentlichen auch nur, an dem Elektrodenkontaktbereich ab. Die polymerisier- und/oder vernetzbaren Verbindungen aus dem ersten Elektrolyten werden also bevorzugt an dem Elektrodenkontaktbereich abgeschieden, wobei besonders bevorzugt eine elektrochemische Polymerisation an der Kontaktfläche stattfindet.

Eine bevorzugte Ausgestaltung des Verfahrens zeichnet sich ferner dadurch aus, dass der sich beim Abscheiden der polymerisier- und/oder vernetzbaren Verbindungen bildende Polymerfilm durch Ionen des Elektrolyten dotiert wird, so dass der Polymerfilm leitfähig wird. Entsprechende Verfahren sind aus dem Stand der Technik bekannt. In dem Patent DE 101 40 666 C2 wird ein solches Verfahren erläutert. Eine bevorzugte Ausgestaltung des Verfahrens zeichnet sich dadurch aus, dass das erste Spannungspotenzial in der Weise gewählt ist, dass der Elektrodenkontaktbereich eine Anode ist. Das zweite Spannungspotenzial kann hierzu in der Weise ausgewählt sein, dass die Gegenelektrode eine Kathode ist.

Da die gebildete Polymerstruktur beim Abscheiden durch Ionen des ersten Elektrolyten dotiert sein kann, kann der erste Elektrolyt die Materialeigenschaften der Polymerstruktur direkt beeinflussen. Die Leitfähigkeit der Polymerstruktur kann somit stark von der Menge der Ionen in dem ersten Elektrolyten und/oder von einer Potentialdifferenz zwischen dem Elektrodenkontaktbereich und der Gegenelektrode abhängen. Um die Leitfähigkeit der Polymerstruktur zu verringern oder zu erhöhen, kann die mit der Polymerstruktur beschichtete beziehungsweise verbundene Elektrode nach dem Polymerisationsprozess und vor dem Galvanikprozess zusammen mit einer zweiten Gegenelektrode in einen "dritten" Elektrolyten getaucht werden, der neben dem Lösungsmittel nur das Salz und/oder keine polymerisier- und/oder vernetzbaren Verbindungen enthält.

Durch Anlegen einer Spannung zwischen der Strukturelektrode und der Gegenelektrode kann die Menge der Ionen in der Polymerstruktur verändert werden. Bei einem Anlegen einer Spannung in umgekehrter Richtung (im Vergleich zu der Spannung beim Polymerisationsprozess) kann die Menge der Ionen in der Polymerstruktur verringert werden. Damit kann die Leitfähigkeit der Polymerstruktur gesenkt werden, insbesondere soweit, dass die Polymerstruktur nahezu isolierend wird. Bei einem Anlegen einer Spannung in gleicher Richtung wie bei dem Polymerisationsprozess, kann die Menge der Ionen in der Polymerstruktur erhöht und/oder die Leitfähigkeit der Polymerstruktur gesteigert werden. Grundsätzlich kann die Leitfähigkeit durch die elektrischen Eigenschaften polymerisier- und/oder vernetzbaren Verbindungen begrenzt sein.

Durch den Polymerisationsprozess kann also eine, insbesondere elektrisch, leitfähige Polymerstruktur auf dem Substrat abgeschieden werden. Die Polymerstruktur kann dazu die gleiche Struktur aufweisen, wie der Elektrodenkontaktbereich. Dies kann dadurch erreicht werden, dass die bevorzugt elektrochemische Polymerisation an dem Kontaktbereich zwischen den Elektrodenkontaktbereich und dem ersten Elektrolyt stattfindet.

Es ist bevorzugt, dass der Polymerfilm nur eine sehr geringe Dicke, insbesondere eine Dicke bis 50 mm, insbesondere von 0,1 nm bis 1 mm, vorzugsweise von 1 µm bis 100 µm, besonders bevorzugt von 20 nm bis 500 nm, aufweist.

Neben dem Polymerisationsprozess zeichnet sich das Verfahren zur Herstellung einer Metallstruktur auf einem Substrat auch durch den Metallgalvanikprozess aus. Der Galvanikprozess wird vorzugsweise nach dem Polymerisationsprozess ausgeführt. Es kann bevorzugt sein, dass für den Galvanikprozess wenigstens ein Teil der polymeren Struktur in Kontakt mit dem, vorzugsweise flüssigen, zweiten Elektrolyten gebracht wird, wobei in den zweiten Elektrolyten ein metallischer Stoff eingebracht ist. Der zweite Elektrolyt kann also einen metallischen Stoff aufweisen. Als metallischer Stoff kommen insbesondere diejenigen Stoffe in Betracht, die elektrisch leitfähig, insbesondere hoch leitfähig, sind. Der metallische Stoff kann ein Reinstoff, ein Gemenge oder ein Gemisch, insbesondere homogenes Gemisch, sein und/oder ein Lot, ein Edelmetall, ein Übergangsmetall, Metallverbindungen, eine Metalllegierung, ein Nanometall und/oder Kupfer, vorzugsweise reines Kupfer, aufweisen oder sein. Außerdem kann der metallische Stoff halbleitend sein und/oder elektrisch nicht leitende Anteile aufweisen. Besonders bevorzugt ist der metallische Stoff Kupfer, Silber, Aluminium, Nickel, Chrom, Zinn, Blei, Gold und/oder Titan oder eine Legierung mit mindestens einem dieser Stoffe. Der metallische Stoff kann ein fester Körper sein. Ferner kann der metallische Stoff zumindest ein Teil einer Elektrode sein. Alternative Ausgestaltungen des metallischen Stoffes sind auch denkbar. So kann der metallische Stoff pulverförmig und/oder krümelig sein. Der, insbesondere pulverige, metallische Stoff oder das Metallsalz kann in und/oder mit dem zweiten Elektrolyten vermischt sein und/oder mit diesem eine Suspension oder Lösung bilden. Grundsätzlich kann der zweite Elektrolyt mit dem eingebrachten metallischen Stoff ein heterogenes Gemisch sein.

In einer besonders bevorzugten Ausgestaltung ist der zweite Elektrolyt flüssig oder in Lösung. Der zweite Elektrolyt kann mit dem eingebrachten metallischen Stoff eine Suspension oder Lösung bilden. Es ist also bevorzugt, dass der zweite Elektrolyt eine Flüssigkeit aufweist, die den metallischen Stoff lösen kann und/oder in der der metallische Stoff suspendierbar ist.

Grundsätzlich kann unter einem, insbesondere flüssigen, Elektrolyten eine elektrisch leitende Lösung verstanden werden, die Ionen, insbesondere Kationen und Anionen, aufweist. Die Ionen können positiv oder negativ geladene Atome und/oder Moleküle sein. Sie können dadurch entstehen, dass Salze, Säuren oder Laugen in positiv oder negativ geladene Atome und/oder Moleküle aufgespalten werden. Die Kationen und/oder Anionen können die Ladungsträger des Elektrolyten sein.

Für den Galvanikprozess kann wenigstens ein Teil der Polymerstruktur mit dem zweiten Elektrolyten in Kontakt gebracht werden. Bevorzugt wird die Polymerstruktur zumindest teilweise in den zweiten Elektrolyten eingetaucht. Bevorzugt wird die gesamte Polymerstruktur mit dem zweiten Elektrolyten in Kontakt gebracht.

Für den Galvanikprozess ist es außerdem vorgesehen, dass über die Polymerstruktur ein zweiter Stromfluss durch den zweiten Elektrolyten erzeugt wird. Hierfür ist es bevorzugt, dass ein Stromfluss zwischen einer Kathode und einer Anode, insbesondere auch durch den Elektrolyten, stattfindet. Die Kathode und die Anode können dazu an eine Spannungsquelle angeschlossen sein. Bevorzugt fließt der zweite Stromfluss durch die Polymerstruktur. Auch deshalb kann es vorgesehen sein, dass die Polymerstruktur zumindest ein Teil der Oberfläche der Kathode ist. Insbesondere kann die Polymerstruktur die Oberfläche der Kathode bilden. Zwischen der Kathode und dem Elektrolyten fließt bevorzugt auch nur im Bereich der Polymerstruktur ein Strom für den Galvanikprozess.

Die Anode kann eine beliebige aus dem Stand der Technik bekannte Anode für eine Galvanisierung sein. Dazu weist die Anode bevorzugt den metallischen Stoff auf. Insbesondere kann die Anode von dem metallischen Stoff im Wesentlich gebildet sein.

Für den Galvanisierungsprozess ist es besonders bevorzugt, dass die Spannung der Anode höher, insbesondere deutlich höher, als die Spannung der Kathode ist. Mit anderen Worten kann die Anode einen Plus-Pol bilden und die Kathode einen Minus-Pol bilden.

Eine vorteilhafte Ausgestaltung des Verfahrens kann sich auch dadurch auszeichnen, dass der metallische Stoff eine Opferelektrode oder mindestens einen Bereich der Oberflächenschicht der Opferelektrode ist.

Es ist außerdem erfindungsgemäß, dass auf den mit dem zweiten Elektrolyten in Kontakt gebrachten Bereich der Polymerstruktur ein leitfähiger Metallfilm der vorgegebenen Struktur gebildet und/oder abgeschieden wird (Metallstruktur). Es ist also bevorzugt, dass eine metallische Schicht, insbesondere aus dem metallischen Stoff, galvanisch auf der Polymerstruktur abgeschieden wird. Durch Anlegen einer Spannung zwischen der Polymerstruktur und einer Gegenelektrode, insbesondere die von dem metallischen Stoff gebildet wird oder diesen aufweist, kann ein Atom oder Molekül des metallischen Stoffes zu einem positiv geladenen Metall-lon (hier: Kation) oxidiert werden. Dieses Metall-lon kann an der Polymerstruktur (hier: Kathode) zu Metall reduziert werden. Dadurch kann eine Abscheidung des metallischen Stoffes an der Polymerstruktur erreicht werden. In Abhängigkeit der Spannungshöhe und/oder der Dauer des Anlegens der Spannung kann die Dicke der abzuscheidenden Metallschicht auf der Polymerstruktur bestimmt und/oder gesteuert werden. Sofern nur ein Teil der Polymerstruktur mit dem zweiten Elektrolyten in Kontakt gebracht wird, findet eine galvanische Abscheidung auch nur in diesem Bereich statt.

An dieser Stelle sei noch einmal deutlich darauf hingewiesen, dass es bevorzugt ist, dass die galvanische Abscheidung des metallischen Stoffes, vorzugsweise nur, im Bereich der Polymerstruktur und/oder auf der Polymerstruktur erfolgt. So ist es bevorzugt, dass auf der Oberfläche der (Struktur-)Elektrode und/oder Kathode, die nicht von der leitfähigen Polymerstruktur bedeckt und/oder gebildet werden, zumindest im Wesentlichen keine galvanische Abscheidung eines metallischen Stoffes erfolgt. Eine Elektrode, insbesondere eine Kathode, deren Oberfläche zumindest teilweise durch die Polymerstruktur gebildet und/oder von der Polymerstruktur bedeckt ist, insbesondere in dem Bereich, der mit dem zweiten Elektrolyten in Kontakt gebracht wird, kann in dem zu der Polymerstruktur komplementären Bereich und/oder in dem übrigen Bereich der Oberfläche isolierend ausgestaltet sein und/oder einen isolierenden Stoff aufweisen und/oder von diesem bedeckt sein. Radial und/oder in der Dicke kann der isolierende Stoff in der Weise ausgestaltet sein, dass die Polymerstruktur und der isolierende Stoff eine im Wesentlichen glatte, ebene und/oder stetig verlaufende Oberfläche ist.

Weiterhin zeichnet sich das erfindungsgemäße Verfahren durch einen Transfer der Metallstruktur auf das Substrat aus, wobei wenigstens ein Teil der Metallstruktur auf das Substrat aufgebracht wird. Dazu kann die Metallstruktur zunächst mit dem Substrat in Kontakt gebracht werden. Insbesondere kann eine Deckfläche der Metallstruktur mit einer Deckfläche des Substrats in Kontakt gebracht werden. Ferner kann die Kontaktfläche und/oder der Kontaktbereich zwischen der Metallstruktur und dem Substrat in der Weise ausgestaltet sein, dass beim und/oder nach dem in Kontakt bringen der Metallstruktur mit dem Substrat eine Verbindung zwischen beiden gebildet wird. Eine Verbindung zwischen dem Substrat und der Metallstruktur kann form-, kraft- und/oder stoffschlüssig sein.

Eine besonders bevorzugte Ausgestaltung des Verfahrens zeichnet sich dadurch aus, dass die auf das Substrat aufgebrachte Metallstruktur und/oder Polymerstruktur durch ein Haftmittel (Substrathaftmittel) mit dem Substrat, vorzugsweise stoffschlüssig, verbunden wird. Ferner ist es bevorzugt, dass das Substrathaftmittel derart gewählt wird, dass eine Haftung zwischen Elektrode und Polymerstruktur schwächer ist als eine Haftung zwischen Substrathaftmittel und Metallstruktur, Substrat und/oder Polymerstruktur. Auch kann das Substrathaftmittel so ausgewählt sein, dass die Metallstruktur, die Polymerstruktur und/oder das Substrat an dem Haftmittel haften können. Das Substrathaftmittel kann, zumindest bereichsweise, ein dünner Film und/oder eine insbesondere dünne Schicht zwischen dem Substrat und der Metallstruktur beziehungsweise Polymerstruktur sein. Das Haftmittel kann vor dem Transfer der Metallstruktur und/oder der Polymerstruktur auf das Substrat, insbesondere bereichsweise, und/oder auf die Metallstruktur, insbesondere bereichsweise, und/oder auf die Polymerstruktur, insbesondere bereichsweise, aufgebracht werden. Nach dem Transfer der Metallstruktur und/oder Polymerstruktur auf das Substrat kann eine haftende Verbindung zwischen dem Substrat und der Metallstruktur beziehungsweise Polymerstruktur auch durch das Haftmittel verursacht sein.

Eine weitere vorteilhafte Ausgestaltung des Verfahrens zeichnet sich dadurch aus, dass die auf das Substrat aufgebrachte Metallstruktur und/oder Polymerstruktur durch ein thermisches Fügeverfahren, insbesondere Löten, Schweißen, Laminieren und/oder Ultraschall, mit dem Substrat, vorzugsweise stoffflüssig, verbunden wird. Für das Löten oder Schweißen kann der Metallstruktur, der Polymerstruktur und/oder dem Substrat, insbesondere gezielt, im Bereich des zu erwartenden Kontaktbereiches zwischen dem Substrat und der Metallstruktur beziehungsweise Polymerstruktur, Energie, vorzugsweise thermische Wärmeenergie, zugeführt werden. Für das Schweißen kann so viel Energie zugeführt werden, dass die Metallstruktur, Polymerstruktur und/oder das Substrat jeweils ihre Liquidus-Temperatur erreichen und sich bei dem anschließenden Abkühlen miteinander verbinden. Für das Löten kann ein Lötmittel verwendet werden, dass zwischen das Substrat und der Metallstruktur beziehungsweise Polymerstruktur positioniert wird und diesem Lötmittel Energie, insbesondere Wärmeenergie, zugeführt wird. Das Lötmittel kann eine geringere Liquidus-Temperatur aufweisen als die Metallstruktur, Polymerstruktur und/oder das Substrat. Dazu kann das Lötmittel auch Nanometall, insbesondere Nanosilber, sein. Das Lötmittel kann, insbesondere beim Abkühlen, die Metallstruktur und das Substrat verbinden.

Das Laminieren kann ein Heiß- oder Kaltlaminieren sein. Das Laminieren kann sich dadurch auszeichnen, dass die Metallstruktur und/oder Polymerstruktur durch eine Klebefolie auf das Substrat geklebt wird. Hierbei kann die Klebefolie die Metallstruktur und/oder die Polymerstruktur auf das Substrat drücken. Bevorzugt ist die Klebefolie nicht in dem direkten Kontaktbereich zwischen der Metallstruktur und dem Substrat oder zwischen der Polymerstruktur und dem Substrat ausgebildet.

Vielmehr kann die Klebefolie in den Bereichen an dem Substrat kleben, die nicht von der Metallstruktur und/oder der Polymerstruktur bedeckt sind. In einer Ausgestaltung kann die Klebefolie eine Klebehülle sein. Hierbei kann die Klebefolie das Substrat und die auf das Substrat aufgebrachte Metallstruktur und/oder Polymerstruktur klebend von außen zusammenhalten. Das Laminieren kann sich dadurch auszeichnen, dass die Metallstruktur und das Substrat und/oder die Polymerstruktur und das Substrat kraftschlüssig miteinander verbunden sind. Der Kraftschluss kann hierbei durch die Klebefolie verursacht sein.

Außerdem können die Metallstruktur und das Substrat und/oder die Polymerstruktur und das Substrat durch Ultraschallfügen und/oder durch Reibschweißen miteinander verbunden sein.

Das erfindungsgemäße Verfahren eignet sich im Allgemeinen zur Herstellung einer Metallstruktur auf einem Substrat. Das Verfahren kann deshalb in verschiedensten Bereichen der Technik Anwendung finden. Besonders vorteilhaft zeichnet sich eine Ausgestaltung des Verfahrens dadurch aus, dass das Substrat eine Leiterplatte ist. Unter einer Leiterplatte kann grundsätzlich ein Trägerelement und/oder eine Trägervorrichtung für elektronische Bauteile und/oder elektrische Leitungsverbindungen verstanden werden. Auf der Leiterplatte können die elektronischen Bauteile und/oder die elektrischen Leitungsverbindungen befestigt werden. Eine Leiterplatte oder das Substrat können elektrisch isolierend sein. Es kann deshalb bevorzugt sein, dass elektronische Bauteile durch elektrische Leiterbahnen miteinander verbunden sind. Eine bevorzugte Ausgestaltung dieses Verfahrens zeichnet sich dadurch aus, dass die Metallstruktur Leiterbahnen sind. Die Metallstruktur kann somit auch die Leiterbahn oder die Leiterbahnen auf einer Leiterplatte (nämlich dem Substrat) sein. Die Metallstruktur kann auch aus zerklüfteten Teilelementen bestehen. Die einzelnen Teilelemente der Metallstruktur können in der Weise ausgestaltet sein, dass sie nicht elektrisch leitend miteinander verbunden sind und/oder nicht stoffschlüssig miteinander verbunden sind.

Gerade für Leiterbahnen kann es vorteilhaft sein, wenn diese einen möglichst geringen elektrischen Widerstand aufweisen oder dessen elektrischer Widerstand durch eine Stoffauswahl bestimmbar ist. Eine bevorzugte Ausgestaltung des Verfahrens zeichnet sich dadurch aus, dass der Galvanisierungsprozess mehrfach nacheinander, insbesondere mit wechselnden und/oder verschiedenen metallischen Stoffen, wie beispielsweise Kupfer, Silber, Platin, und/oder Gold, ausgeführt wird. Der Galvanisierungsprozess kann also mehrfach nacheinander ausgeführt werden. So kann die Galvanisierung in der Weise ausgeführt werden, dass zumindest ein Galvanisierungsprozess mit einem besonders hoch leitfähigen metallischen Stoff, wie beispielweise Silber, Gold oder Platin, ausgeführt wird. So ist es beispielsweise bekannt, dass aufgrund des Skin-Effektes die Stromdichte am äußeren Rand eines elektrischen Leiters höher sein kann, als im Kernbereich. Um eine Metallstruktur mit möglichst einem geringen, insbesondere effektiven, Widerstand bereitzustellen, kann es vorteilhaft sein, dass der erste und/oder letzte von mehreren Galvanikprozessschritten mit einem besonders hoch leitfähigen metallischen Stoff durchgeführt wird. So könnte beispielsweise durch ein Abscheidung von Nickel und Kupfer eine verbesserte Lötbarkeit erreicht werden. Dazu könnte die Abscheidung von Kupfer vor der Abscheidung von Nickel erfolgen. Auf diese Weise kann das Nickel außen angeordnet sein, insbesondere um ein möglichst einfaches Löten zu ermöglichen.

Grundsätzlich kann sich das erfindungsgemäße Verfahren durch die bevorzugt wesentlichen Merkmale, nämlich den Polymerisationsprozess, den Galvanikprozess und den Transfer der Metallstruktur auf das Substrat, auszeichnen. Eine bevorzugte Ausgestaltung des Verfahrens zeichnet sich dadurch aus, dass der Galvanikprozess auf der polymerbeschichteten Strukturelektrode stattfindet. Es kann also bevorzugt sein, dass die Polymerstruktur nach dem Polymerisationsprozess und vor dem Galvanikprozess nicht von der Strukturelektrode entfernt wird. Die Polymerstruktur kann mit der Strukturelektrode, insbesondere elektrisch, kontaktiert sein. Insbesondere kann die Polymerstruktur rückseitig kontaktiert sein. Es ist also möglich, dass die Strukturelektrode für den Polymerisationsprozess zumindest teilweise in Kontakt mit dem ersten elektrischen Elektrolyt gebracht wird. Hierbei kann sich die Polymerstruktur auf der Strukturelektrode bilden bzw. abscheiden. Danach kann die Strukturelektrode aus dem ersten Elektrolyt herausgenommen werden. Gegebenenfalls kann eine Säuberung der Oberfläche stattfinden. Dies kann insbesondere ein Abspülen der Oberfläche mit einer Flüssigkeit sein. Die Strukturelektrode mit der an ihr haftenden Polymerstruktur kann danach zumindest teilweise in Kontakt mit dem zweiten Elektrolyten gebracht werden. Durch den Galvanikprozess kann eine Abscheidung des metallischen Stoffes auf der Polymerstruktur erfolgen. Der Strom kann hierbei durch die Strukturelektrode, insbesondere durch den Elektrodenkontaktbereich der Strukturelektrode, durch die Polymerstruktur, die rückseitig vorzugsweise nur mit dem Elektrodenkontaktbereich der Strukturelektrode, insbesondere elektrisch leitend, kontaktiert ist, fließen, so dass im Wesentlichen nur an der Polymerstruktur eine Metallabscheidung erfolgt. Bei dem Galvanikprozess und/oder bei dem Polymerisationsprozess kann die Schichtdicke der Metallstruktur bzw. der Polymerstruktur durch die Stromstärke, durch die Höhe der Spannung und/oder durch die elektrische Ladung, also aus dem Produkt von Strom und Zeit, bestimmt und/oder gesteuert werden.

Das erfindungsgemäße Verfahren ist auch dann besonders vorteilhaft, wenn das Verfahrensprodukt, nämlich die Metallstruktur auf dem Substrat, möglichst kostengünstig und/oder möglichst schnell hergestellt werden kann. Ein besonders bevorzugtes Verfahren kann sich dadurch auszeichnen, dass die kostenintensiven Bauteile wieder verwendbar sind und/oder nicht in mehreren Verfahrensschritten "blockiert" werden (sondern vorzugsweise nach einem der Verfahrensschritte wieder "freigegeben" werden).

In einer vorteilhaften Ausgestaltung ist die Strukturelektrode wieder verwendbar. Für das Oberflächenmaterial der Strukturelektrode, insbesondere für den Elektrodenkontaktbereich und/oder für den Elektrodenkomplementärbereich, kann ein Material gewählt werden, an dem die Polymerstruktur, insbesondere hinreichend gut, aber vorzugsweise nicht zu stark, haften kann. Vorteilhaft kann das Oberflächenmaterial der Strukturelektrode im Elektrodenkontaktbereich aus Platin, Gold oder Edelstahl bestehen oder Platin, Gold oder Edelstahl aufweisen. Beispielsweise kann die Oberfläche der Strukturelektrode im Elektrodenkontaktbereich mit einem Platin, Gold oder Edelstahl aufweisenden Stoff, insbesondere durch Aufdampfung, beschichtet sein. Auch kann die Oberfläche der Strukturelektrode poliert sein. So kann die Rauheit der Oberfläche der Strukturelektrode möglichst klein oder an die zu erzielende Haftung mit der Polymerstruktur angepasst sein. Der Elektrodenkomplementärbereich der Strukturelektrode kann aus Glas und/oder Diamond like Carbon (DLC) aufweisen oder aus der Stoffe bestehen. Grundsätzlich ist der Elektrodenkomplementärbereich in der Weise ausgestaltet, dass an diesem ein Stoff nur sehr gering haften kann. Die Kontaktierung der Elektrodenkontaktbereiche kann durch innen liegende, elektrische Leitungsverbindungen erfolgen.

Für eine bevorzugt Ausgestaltung ist die Strukturelektrode aus hochdotiertem Silizium. Das Silizium ist an der Oberfläche oxidiert, so dass sich eine isolierende Oxidschicht darauf befindet, wobei die Oberfläche entsprechend der vorgebbaren Struktur von der Oxidschicht befreit ist und dort mit Cr/Au bedeckt ist.

Grundsätzlich können auf der Rückseite der Strukturelektrode alle miteinander, insbesondere mittels eines leitfähigen Wafers, kontaktiert sein.

Ferner hat sich gezeigt, dass bei einer Verwendung eines organischen Lösungsmittels für den ersten Elektrolyten sich die abgeschiedene Polymerstruktur besonders leicht von der ersten Elektrode lösen lässt. Eine bevorzugte Ausgestaltung des Verfahrens zeichnet sich insbesondere deshalb dadurch aus, dass der Elektrolyt ein organisches Lösungsmittel aufweist.

Durch eine geeignete Stoffwahl für das Oberflächenmaterial der Strukturelektrode, durch eine Erhöhung der mechanischen Widerstandsfähigkeit der Oberfläche der Strukturelektrode und/oder durch den gezielten Einsatz von Lösungsmitteln, insbesondere organischen Lösungsmitteln, für den ersten Elektrolyten kann es erreicht werden, dass die Strukturelektrode weder durch den Polymerisationsprozess noch durch ein Entfernen der Polymerstruktur von der Strukturelektrode angegriffen und/oder beschädigt wird. Die Strukturelektrode kann deshalb wiederholt zur Herstellung der Polymerstruktur verwendet werden. Ferner kann auch der erste und/oder zweite Elektrolyt mehrfach bis zur Erschöpfung der darin eingebrachten Verbindungen verwendet und/oder schrittweise bzw. kontinuierlich regeneriert werden.

Grundsätzlich ist eine Strukturierung der Oberfläche der Strukturelektrode nur einmal notwendig. Dazu kann die Oberfläche der Strukturelektrode in den Elektrodenkontakt- und Elektrodenkomplementärbereich aufgeteilt werden. Die beiden Bereiche können jeweils mehrere Teilbereiche aufweisen. Es können somit beliebige, insbesondere auch kostspielige, Verfahren aus dem Stand der Technik zur Strukturierung der Strukturelektrode eingesetzt werden. Der Kostenbeitrag zu den Gesamtherstellungskosten der Metallstruktur auf dem Substrat kann bei einer Massenproduktion aufgrund der Wiederverwendbarkeit der Strukturelektrode im Wesentlichen vernachlässigt werden. Ferner kann es den Vorteil haben, dass nur dort ein leitfähiges Polymer abgeschieden wird, wo es durch die vorgebbare Struktur vorgesehen ist. Entsprechendes gilt auch für den Galvanikprozess. Der Materialverbrauch und die damit verbundenen Kosten können bei der Herstellung der Metallstruktur auf dem Substrat somit auf ein Minimum beschränkt werden.

Es ist also grundsätzlich möglich, dass die Polymerstruktur zerstörungsfrei von der Strukturelektrode getrennt werden kann. Eine vorteilhafte Ausgestaltung des Verfahrens zeichnet sich dadurch aus, dass wenigstens ein Teil der an dem Substrat haftenden Polymerstruktur und/oder Metallstruktur, insbesondere zerstörungsfrei, von der Strukturelektrode abgezogen wird. Grundsätzlich kann das Substrat starr sein und/oder fest sein. Vorteilhaft ist es aber auch möglich, dass das Substrat flexibel und/oder elastisch und/oder biegbar ist. So kann sich das Substrat an die Form der Elektrode, Polymerstruktur und/oder Metallstruktur anpassen lassen oder an diese "anschmiegbar" sein. Außerdem kann die Polymerstruktur und/oder Metallstruktur stärker an dem Substrat haften als an der Strukturelektrode. Dazu kann die Oberfläche des Substrats in der Weise angepasst und/oder ausgestaltet sein, dass das Substrathaftmittel stärker an dem Substrat als an der Strukturelektrode haftet. Alternativ kann die Oberfläche der Strukturelektrode, insbesondere die Elektrodenkomplementärbereiche, mit einer Antihaftbeschichtung versehen sein, insbesondere damit das Substrathaftmittel dort nicht haften kann.

Auch kann es vorgesehen sein, dass die Polymerstruktur nicht in direkten Kontakt mit dem Substrat kommt. Hierbei kann die durch das Substrathaftmittel vermittelte Haftung der Metallstruktur an dem Substrat größer sein, als die Haftung der Metallstruktur an der Polymerstruktur und/oder größer als die Haftung der Polymerstruktur an der Elektrodenkontaktfläche und/oder größer als die mechanische Stabilität der Polymerstruktur.

Um den besonderen Vorteil einer weiteren Ausgestaltung zu erläutern, sei zunächst Folgendes erläutert. Die Strukturelektrode hat nicht nur die Aufgabe einer Elektrode. Durch die Struktur des Elektrodenkontaktbereiches, nämlich die vorgebbare Struktur, bestimmt die Strukturelektrode zumindest mittelbar auch die Struktur der Polymerstruktur und/oder der Metallstruktur. Die Strukturelektrode hat also zumindest zweierlei Aufgaben. Eine erste Aufgabe kann die Ermöglichung eines Stromflusses sein. Eine zweite Aufgabe kann die Formgebung der Polymerstruktur und/oder Metallstruktur sein. Für zumindest eine Ausgestaltung des Verfahrens wäre es vorteilhaft, wenn die Strukturelektrode von der ersten Aufgabe befreit werden könnte, dass der zweite Stromfluss nicht durch die Strukturelektrode fließt und/oder dass die Abscheidung einer Metallstruktur auf der Polymerstruktur unabhängig von der Strukturelektrode erfolgen kann.

Eine vorteilhafte Ausgestaltung des Verfahrens zeichnet sich durch einen Transfer wenigstens eines Teils der Polymerstruktur und/oder wenigstens eines Teils der Metallstruktur auf ein Transfersubstrat aus. Dabei kann wenigstens ein Teil der Polymerstruktur und/oder der Metallstruktur mit dem Transfersubstrat in Verbindung gebracht werden. Der Transfer des wenigstens einen Teils der Polymerstruktur auf das Transfersubstrat kann nach dem Polymerisationsprozess und vor dem Galvanikprozess erfolgen. Der Transfer wenigstens eines Teils der Polymerstruktur und wenigstens eines Teils der, insbesondere mit der Polymerstruktur verbundenen, Metallstruktur auf ein Transfersubstrat kann nach dem Polymerprozess und vor dem Transfer der Metallstruktur auf das Substrat erfolgen. Eine Verbindung zwischen der Polymerstruktur und/oder der Metallstruktur mit dem Transfersubstrat kann eine kraft-, form- und/oder stoffschlüssige Verbindung sein. Vorteilhaft kann wenigstens ein Teil der Polymerstruktur oder wenigstens ein Teil der Metallstruktur durch ein Haftmittel (Transferhaftmittel), insbesondere adhäsives Material, mit dem Transfersubstrat, vorzugsweise stoffschlüssig, verbunden sein. Das Transferhaftmittel kann so ausgewählt sein, dass das Transfersubstrat, die Polymerstruktur und/oder die Metallstruktur an dem Transferhaftmittel haften können. Das Transferhaftmittel kann ein selbsthärtendes Mittel sein. Auch kann das Transferhaftmittel ein unter Energiezufuhr, insbesondere thermischer Energiezufuhr, aushärtendes Haftmittel sein. Ferner kann das Transferhaftmittel ein Kleber sein. Das Transferhaftmittel kann, insbesondere für die Haftwirkung, zwischen dem Transfersubstrat und der Polymerstruktur und/oder Metallstruktur ausgebildet sein. Auch kann das Transferhaftmittel elektrisch isolierend sein.

Eine vorteilhafte Ausgestaltung des Verfahrens zeichnet sich durch einen Transfer wenigstens eines Teils der Polymerstruktur und/oder wenigstens eines Teils der Metallstruktur auf das Substrat aus. Dabei kann wenigstens ein Teil der Polymerstruktur und/oder der Metallstruktur mit dem Substrat in Verbindung gebracht werden. Der Transfer des wenigstens einen Teils der Polymerstruktur auf das Substrat kann nach dem Polymerisationsprozess und vor dem Galvanikprozess erfolgen. Der Transfer wenigstens eines Teils der Polymerstruktur und wenigstens eines Teils der, insbesondere mit der Polymerstruktur verbundenen, Metallstruktur auf das Substrat kann nach dem Galvanikprozess erfolgen. Eine Verbindung zwischen der Polymerstruktur und/oder der Metallstruktur mit dem Substrat kann eine kraft-, form- und/oder stoffschlüssige Verbindung sein. Vorteilhaft kann wenigstens ein Teil der Polymerstruktur oder wenigstens ein Teil der Metallstruktur durch das Substrathaftmittel, insbesondere adhäsives Material, mit dem Substrat, vorzugsweise stoffschlüssig, verbunden sein. Das Substrathaftmittel kann so ausgewählt sein, dass das Transfersubstrat, die Polymerstruktur und/oder die Metallstruktur an dem Substrathaftmittel haften können. Das Substrathaftmittel kann ein selbsthärtendes Mittel sein. Auch kann das Substrathaftmittel ein unter Energiezufuhr, insbesondere thermischer Energiezufuhr, aushärtendes Haftmittel sein. Ferner kann das Substrathaftmittel ein Kleber sein. Das Substrathaftmittel kann, insbesondere für die Haftwirkung, zwischen dem Substrat und der Polymerstruktur und/oder dem Substrat und Metallstruktur ausgebildet sein. Auch kann das Substrathaftmittel elektrisch isolierend sein.

Ein bevorzugte Ausgestaltung zeichnet sich dadurch aus, dass zur Bildung des Transfersubstrats ein Fluid ausgehärtet wird. Das Fluid kann hierzu durch Entziehen eines Lösungsmittels, Beleuchten mit UV-Strahlung und/oder Beifügen eines Härters ausgehärtet werden. Die Härtung kann auch Energie- und/oder Wärmezufuhr ausgehärtet werden.

Eine weitere vorteilhafte Ausgestaltung des Verfahrens zeichnet sich dadurch aus, dass zur Bildung des Transfersubstrats eine Lösung aus einem in einem, insbesondere flüchtigen, Lösungsmittel gelösten, nicht leitfähigen Polymer (Transferpolymer), insbesondere UV-aushärtend, 2-Komponenten-Kleber (Epoxy), Klebefilme und/oder Polymerfolien mit Kleberschicht, auf die Polymerstruktur, die Metallstruktur und/oder auch auf den Elektrodenkomplementärbereich, insbesondere großflächig, aufgebracht wird. Hierbei kann das Lösungsmittel ein organisches Lösungsmittel sein. Die Verdampfungstemperatur des Lösungsmittels kann, insbesondere deutlich, niedriger als die Verdampfungstemperatur oder Sublimationstemperatur des Transferpolymers sein. Zur Bildung des Transfersubstrats kann das Lösungsmittel in den gasförmigen Aggregatzustand überführt werden. Diese Überführung kann durch Energie- oder Wärmezufuhr erfolgen. Die Wärme- oder Energiezufuhr kann in der Weise erfolgen, dass das Transferpolymer nicht in den gasförmigen Aggregatzustand überführt wird. Auch kann das Transferpolymer so gewählt sein, dass die Polymerstruktur und/oder die Metallstruktur an dem Transferpolymer haften, insbesondere dass sie an dem Transferpolymer stärker haften als an der Strukturelektrode.

Bereits zuvor wurde erläutert, dass der wenigstens ein Teil der an dem Substrat haftenden Polymerstruktur und/oder Metallstruktur, vorzugsweise zerstörungsfrei, von der Strukturelektrode getrennt und/oder abgezogen werden kann. Außerdem wurden dazu vorteilhafte Merkmale und Zusammenhänge erläutert, die für eine zerstörungsfreie Abtrennung verantwortlich sind oder diese maßgeblich begünstigen. Entsprechendes gilt auch für das Transfersubstrat. Eine vorteilhafte Ausgestaltung des Verfahrens zeichnet sich dadurch aus, dass wenigstens ein Teil der an dem Transfersubstrat haftenden Polymerstruktur und/oder Metallstruktur, vorzugsweise zerstörungsfrei, von der Strukturelektrode getrennt und/oder abgezogen werden kann. Mit anderen Worten kann die an dem Transfersubstrat haftende Polymerstruktur oder Metallstruktur nach dem Polymerisationsprozess und vor dem Galvanikprozess, insbesondere zerstörungsfrei, abgetrennt und/oder abgezogen werden. Nach dem Galvanikprozess und vor dem Transfer der Metallstruktur auf das Substrat können die Polymerstruktur und die Metallstruktur, die durch den Galvanikprozess mit der Polymerstruktur verbunden ist, insbesondere zerstörungsfrei, von der Strukturelektrode getrennt und/oder abgezogen werden. Durch das Transferhaftmittel können die Polymerstruktur und/oder Metallstruktur stärker an dem Transfersubstrat haften als an der Strukturelektrode.

Ein weiteres bevorzugtes Verfahren zeichnet sich dadurch aus, dass das Transferpolymer und/oder das Transferhaftmittel so ausgewählt wird und/oder die Oberfläche des Elektrodenkomplementärbereiches in der Weise mechanisch und/oder chemisch behandelt ist, dass der Elektrodenkomplementärbereich, insbesondere sehr schwach, an dem Transfersubstrat und/oder an dem Transferhaftmittel haftet, und/oder dass der Elektrodenkomplementärbereich, insbesondere deutlich, schwächer als die Polymerstruktur und/oder die Metallstruktur an dem Transfersubstrat und/oder dem Transferhaftmittel haften. Der Elektrodenkomplementärbereich kann beispielsweise antihaftbeschichtet und/oder poliert sein. Der Elektrodenkomplementärbereich kann auch eine, insbesondere sehr, geringe Rauhigkeit aufweisen. Die Oberfläche der Strukturelektrode im Bereich des Elektrodenkomplementärbereiches kann beispielsweise Oxide, Glas oder ähnliche, vorzugsweise elektrisch isolierende Stoffe, aufweisen und/oder aus diesen bestehen.

Eine weitere vorteilhafte Ausgestaltung des Verfahrens zeichnet sich dadurch aus, dass zumindest die Metallstruktur und/oder zumindest ein Teil der Metallstruktur, vorzugsweise zerstörungsfrei, von der Strukturelektrode getrennt und/oder abgezogen werden kann. Vorteilhaft kann die Polymerstruktur beim Abtrennen, insbesondere von der Strukturelektrode, eine Sollbruchstelle und/oder eine Sollbruchschicht sein. Dass die Polymerstruktur als Sollbruchstelle und/oder als Sollbruchschicht wirkt, kann für verschiedene (Teil-) Verfahrensschritte genutzt werden. Sind die Metallstruktur und/oder zumindest mittelbar die Polymerstruktur, insbesondere haftend, mit dem Substrat oder Transfersubstrat verbunden, kann die Metallstruktur von der Strukturelektrode getrennt und/oder abgezogen werden, indem die Polymerstruktur unter Krafteinwirkung zwischen der Strukturelektrode und der Metallstruktur zerbricht, zerrissen wird und/oder plastisch in der Weise verformt wird, dass die Polymerstruktur zumindest in zwei Teile zerteilt wird. Hierbei kann sich die Polymerstruktur in mehrere Teile aufteilen. So kann ein Teil der Polymerstruktur an der Metallstruktur haften. Ein anderer Teil kann an der Strukturelektrode haften.

Es wäre vorteilhaft, anhand der Stoffeigenschaften eine möglichst einfache Trennung der Metallstruktur von der Polymerstruktur, des Transfersubstrats und/oder der Strukturelektrode zu ermöglichen. Bereits zuvor wurde erläutert, dass die Polymerstruktur eine Sollbruchstelle und/oder eine Sollbruchschicht sein kann.

Eine vorteilhafte Ausgestaltung des Verfahrens zeichnet sich dadurch aus, dass die Metallstruktur, das mit der Metallstruktur verbundene Substrat und/oder das mit der Metallstruktur verbundene Transfersubstrat von zumindest einem Teil der Polymerstruktur getrennt wird, und zwar insbesondere durch ein Lösen und/oder Ätzen zumindest eines Teils der Polymerstruktur durch ein, vorzugsweise flüssiges und/oder vorzugsweise die Polymerstruktur lösendes, Lösungsmittel, das die Metallstruktur insbesondere im Wesentlichen nicht löst oder ätzt, und/oder insbesondere durch ein Verflüssigen der Polymerstruktur durch eine Energie-und/oder Wärmezufuhr, wobei die Polymerstruktur einen niedrigeren Schmelzpunkt als die Metallstruktur aufweist, und/oder insbesondere durch eine Vergasung der Polymerstruktur in den Gaszustand durch eine Energie- und/oder Wärmezufuhr, wobei die Vergasungstemperatur oder Sublimationstemperatur der Polymerstruktur niedriger als die Schmelztemperatur der Metallstruktur ist, und/oder insbesondere durch ein mechanisches Abtrennen, beispielsweise durch ein Wasserstrahl-, Luftstrahl-, Rakel-, Sandstrahl- und/oder Schleif-Verfahren.

Durch die zuvor erläuterten Ausgestaltungen kann die Polymerstruktur, die Strukturelektrode und/oder das Transfersubstrat von der Metallstruktur entfernt werden. Die zuvor genannten Verfahren erlauben es also, dass die Metallstruktur durch die Zerstörung zumindest eines Teils der Polymerstruktur oder einem anderen Gegenstand, wie beispielsweise dem Transfersubstrat, zerstörungsfrei getrennt und/oder zerstörungsfrei, insbesondere von der Strukturelektrode, abgezogen werden kann.

So kann eine Polymerstruktur, die zwischen der Metallstruktur und der Strukturelektrode oder dem Transfersubstrat ist durch Ätzen entfernt werden. Das Substrat, das Transfersubstrat, das Transferhaftmittel, das Substrathaftmittel und/oder die Strukturelektrode können in der Weise ausgestaltet sein, dass sie durch das Ätzen nicht angegriffen wird und/oder beschädigt werden. Analoge Überlegungen können auch für die Temperaturabhängigkeit gelten. So kann die Polymerstruktur auf eine Temperatur erhitzt werden, bei der sie flüssig ist und/oder verdampft. Sodann kann die Metallstruktur von dem Substrat und/oder dem Transfersubstrat getrennt werden. Denn die flüssige Polymerstruktur weist annähernd keine Haftwirkung mehr auf. Für eine in den gasförmigen Aggregatzustand überführte Polymerstruktur gilt dies analog, denn die vergaste Polymerstruktur weist keine Haftwirkung mehr auf.

Grundsätzlich besteht auch die Möglichkeit, dass das Substrat, die Strukturelektrode, das Substrathaftmittel, das Transferhaftmittel und/oder das Transfersubstrat nicht ausreichend resistent gegen chemische Einwirkungen und/oder gegen ätzende Lösungen ist. Es kann deshalb auch in diesem Sinne vorteilhaft sein, eine Möglichkeit zur Verfügung zu stellen, die ein Trennen der Metallstruktur von zumindest einem Teil der Polymerstruktur erlaubt. Eine vorteilhafte Ausgestaltung des Verfahrens zeichnet sich dadurch aus, dass die Polymerstruktur eine geringere Zug- und oder Bruchfestigkeit als die Strukturelektrode, die Strukturelektrodenoberfläche, die Metallstruktur, das Substrathaftmittel, das Transferhaftmittel, das Transfersubstrat und/oder das Substrat aufweist. Die Metallstruktur kann sodann mechanisch durch Krafteinwirkung von zumindest einem Teil der Polymerstruktur getrennt werden. Die Polymerstruktur wirkt aufgrund der geringeren Zug- und/oder Bruchfestigkeit als Sollbruchstelle und/oder Sollbruchschicht.

Grundsätzlich kann sich die Erfindung auch durch einen Transfer der Metallstruktur von dem Transfersubstrat auf das Substrat auszeichnen. Für den Transfer wurden auch beispielhaft das Transferhaftmittel und/oder das Substrathaftmittel eingeführt. Eine vorteilhafte Ausgestaltung des Verfahrens zeichnet sich dadurch aus, dass das Substrathaftmittel und das Transferhaftmittel unterschiedliche Haftmittel, insbesondere unterschiedliche Klebstoffe, sind. Das Substrathaftmittel und das Transferhaftmittel können unterschiedliche Schmelzpunkte (bzw. -Temperaturen) ausweisen und/oder das Transferhaftmittel einen, insbesondere deutlich, niedrigeren Schmelzpunkt als das Substrathaftmittel aufweisen. Auch kann das Substrathaftmittel und das Transferhaftmittel unterschiedliche Sublimationspunkte, und/oder Vergasungstemperaturen aufweisen und/oder das Transferhaftmittel einen, insbesondere deutlich niedrigeren Sublimationspunkt und/oder niedrigere Vergasungstemperatur als das Substrathaftmittel aufweisen. Durch zumindest eine der zuvor angeführten Eigenschaftsunterschiede zwischen dem Transferhaftmittel und dem Substrathaftmittel ist es möglich, die Metallstruktur von dem Transfersubstrat auf das Substrat zu transferieren beziehungsweise zu übertragen. Durch eine Energiezufuhr kann das Transferhaftmittel in einen Zustand überführt werden, in dem das Transferhaftmittel deutlich geringer an der Metallstruktur haftet als das Substrathaftmittel. Eine vorteilhafte Ausgestaltung des Verfahrens zeichnet sich dadurch aus, dass das Transferhaftmittel beim Abtrennen des Transfersubstrats, insbesondere von der Metallstruktur, eine Sollbruchschicht und/oder eine Sollbruchstelle ist. Insbesondere in diesem Sinne zeichnet sich eine vorteilhafte Ausgestaltung des Verfahrens auch dadurch aus, dass das Transferhaftmittel in einem Lösungsmittel, insbesondere Wasser, Alkohol, Aceton, Methanol, Ethanol, Isopropanol, NMP und/oder Dichlormethan, lösbar ist. Bevorzugt ist das Substrathaftmittel und/oder das Substrat nicht durch ein Lösungsmittel lösbar, dass das Transferhaftmittel löst.

Bereits zuvor wurde erläutert, dass der Einsatz eines Transfersubstrates sinnvoll sein kann, insbesondere um die Strukturelektrode für eine wiederholte Durchführung des Verfahrens freizugeben. Vor dem Galvanikprozess ist es alternativ möglich, die Polymerstruktur auf das Transfersubstrat zu transferieren. Nach dem Galvanikprozess auf der Strukturelektrode ist es möglich, die Metallstruktur und die Polymerstruktur auf das Transfersubstrat zu transferieren. Der Transfer auf das Transfersubstrat kann nach einem aus dem Stand der Technik bekannten, geeigneten Verfahren erfolgen. Eine bevorzugte Ausgestaltung des erfindungsgemäßen Verfahrens zeichnet sich dadurch aus, dass zur Bildung des Transfersubstrates, ein insbesondere organischer (beispielsweise auf Polyurethanbasis), selbst härtender, photochemisch härtender und/oder thermisch härtender Stoff, vorzugsweise Silikon- oder Heißkleber, auf die Polymerstruktur, die Metallstruktur und/oder auf den Elektrodenkomplementärbereich, insbesondere großflächig, aufgebracht wird. Hierbei kann der, vorzugsweise selbsthärtende, Stoff so ausgewählt sein, dass die Polymerstruktur und/oder die Metallstruktur an dem vorzugsweise selbsthärtenden Stoff haften. Für die Haftung zwischen dem Transfersubstrat und der Polymerstruktur und/oder der Metallstruktur ist hier ein Transferhaftmittel nicht unbedingt notwendig. Vielmehr kann das hier dargestellte Transfersubstrat ausreichend an der Polymerstruktur und/oder der Metallstruktur haften. Das Transferhaftmittel kann form-, kraft- oder stoffschlüssig mit dem Transfersubstrat, der Polymerstruktur und/oder der Metallstruktur verbunden sein. Insbesondere deshalb kann das Transfersubstrat, insbesondere form-, kraft- oder stoffschlüssig, mit der Polymer- und/oder Metallstruktur verbunden sein. Eine derartige stoffschlüssige Verbindung kann dadurch verursacht sein, dass das Polymer des Transferhaftmittels und/oder des Transferpolymers eine chemische Bindung mit dem Transfersubstrat, der Polymerstruktur und/oder der Metallstruktur aufweist oder bildet. Ferner kann sich das Polymer des Transferhaftmittels und/oder des Transferpolymers während dessen Aushärtung ausdehnen, so dass sich das Transfersubstrat, die Polymerstruktur und/oder die Metallstruktur formschlüssig miteinander verbinden.

Findet der Transfer der Polymerstruktur nach dem Polymerisationsprozess und vor dem Galvanikprozess statt, oder soll beispielsweise ein weiterer Galvanikprozess nach dem Transfer der Polymerstruktur und der Metallstruktur auf das Transfersubstrat stattfinden, kann der Galvanikprozess auch mittelbar auf dem Transfersubstrat stattfinden. Eine bevorzugte Ausgestaltung des Verfahrens zeichnet sich durch einen Galvanikprozess auf der mit dem Transfersubstrat und/oder Substrat verbundenen Polymerstruktur aus. Der Galvanikprozess kann also auf der Polymerstruktur stattfinden, die an dem Transfersubstrat und/oder Substrat haftet. Bei dem Galvanikprozess mit der Strukturelektrode kann der metallische Stoff bevorzugt auf der von der Strukturelektrode abgewandten Seite der Polymerstruktur und/oder der Metallstruktur abgeschieden werden. Die Abscheidung kann in analoger Weise mit dem Transfersubstrat und/oder Substrat erfolgen. So kann bei dem Galvanikprozess der metallische Stoff auf der von dem Transfersubstrat und/oder Substrat abgewandten Seite der Polymerstruktur oder der Metallstruktur abgeschieden werden.

Bei einem Galvanikprozess, der insbesondere mittelbar auf der Elektrode stattfinden kann, kann die Polymerstruktur und/oder die Metallstruktur über den Elektrodenkontaktbereich der Elektrode elektrisch leitend kontaktiert sein. Bei einem Transfer der Polymerstruktur und der Metallstruktur auf ein Transfersubstrat kann diese Kontaktierung unterbrochen sein. Insbesondere wenn die Elektrode von der Polymerstruktur getrennt wird, besteht diese Kontaktierung nicht mehr. Insbesondere deshalb zeichnet sich eine bevorzugte Ausgestaltung des Verfahrens dadurch aus, dass die Polymerstruktur und/oder Metallstruktur mit dem Transfersubstrat elektrisch kontaktiert sind. Dazu kann das Transfersubstrat zumindest teilweise, insbesondere an der Oberfläche, elektrisch leitend ausgestaltet sein. Eine bevorzugte Ausgestaltung des Verfahrens zeichnet sich dadurch aus, dass die Oberfläche des Transfersubstrates einen elektrisch leitenden Stoff aufweist. Der elektrisch leitende Stoff kann auch eine, insbesondere großflächige, zusammenhängende Oberfläche des Transfersubstrates bilden, insbesondere diejenigen, die der Polymerstruktur zugewandt ist. Mit anderen Worten kann das Transfersubstrat einen größeren Bereich mit einer elektrisch leitenden Oberfläche aufweisen. Auf diesen Bereich kann die Polymerstruktur und/oder Metallstruktur transferiert werden. Somit kann durch den Transfer die Polymerstruktur durch das Transfersubstrat elektrisch miteinander kontaktiert sein. Insbesondere kann jedes Teilelement der Polymerstruktur elektrisch miteinander kontaktiert sein. Dazu kann der elektrisch leitende Stoff des Transfersubstrates einen geringen spezifischen Widerstand aufweisen. Insbesondere ist der elektrisch leitende Stoff der Oberfläche des Transfersubstrates ein metallischer Stoff und/oder ein Metall, insbesondere Silber, Gold und/oder Platin. Soweit zusammenfassend kann sowohl die Oberfläche des Transfersubstrates elektrisch leitend sein als auch die Polymerstruktur und/oder die Metallstruktur, die auf das Transfersubstrat transferiert sein können. Hierbei ist es besonders vorteilhaft, wenn das Transferhaftmittel elektrisch leitend, insbesondere elektrisch sehr gut leitend, ist.

Es ist nun weniger bevorzugt, das zuvor beschriebene Transfersubstrat mit der daran haftenden Polymerstruktur und/oder zumindest mittelbar anhaftenden Metallstruktur mit einem zweiten Elektrolyten in Kontakt zu bringen. Denn bei einem mit diesen Randbedingungen ausgeführten Galvanikprozess könnte der metallische Stoff aus dem zweiten Elektrolyten auch direkt auf dem Transfersubstrat abgeschieden werden. Es kann deshalb vorteilhaft sein, die unmittelbare Zwischenräume der Polymerstruktur vor dem Eindringen eines Elektrolyten und/oder eines metallischen Stoffes zu schützen. Das kann insbesondere für den zuvor erläuterten weniger bevorzugten Fall als auch für einen beliebig anderen mit dem erfindungsgemäßen Verfahren in Beziehung stehenden Fall sinnvoll sein. Eine bevorzugte Ausgestaltung des Verfahrens zeichnet sich durch ein Füllen der Zwischenräume der Polymerstruktur aus. Hierbei kann eine Lösung aus einem in einem, insbesondere flüchtigen, Lösungsmittel gelösten, nicht leitfähigen Polymer auf wenigstens einen Teil des nicht von der Polymerstruktur abgedeckten Bereiches der Elektrode (insbesondere also der Komplementärbereich) oder des Transfersubstrates aufgebracht werden. Die Lösung kann dabei zunächst großflächig auf der Polymerstruktur und/oder auf beziehungsweise in die Zwischenräume verteilt werden. Danach kann die Oberfläche der Polymerstruktur abgezogen werden. Auf diese Weise kann erreicht werden, dass die Lösung und/oder das nichtleitfähige Polymer nur in den Zwischenräumen der Polymerstruktur und/oder Metallstruktur ist. Das flüchtige Lösungsmittel kann danach in den gasförmigen Aggregatzustand, insbesondere durch Energie- oder Wärmeenergiezufuhr, überführt werden. Es ist also möglich, dass das Transfersubstrat großflächig eine elektrisch leitende Oberfläche aufweist. Mit dieser kann die Polymerstruktur und/oder die Metallstruktur, insbesondere elektrisch leitend, verbunden sein. Die Zwischenräume der Polymerstruktur können elektrisch isolierend ausgestaltet sein. Dadurch ist es möglich, dass das Transfersubstrat mit der Polymerstruktur und/oder mit der Metallstruktur in Kontakt mit einem zweiten Elektrolyten gebracht werden kann und der Galvanikprozess ausgeführt werden kann, wobei sich durch ein Stromfluss der metallische Stoff aus dem zweiten Elektrolyten auf der Polymerstruktur und/oder der Metallstruktur abscheidet. Hier findet insbesondere keine direkte Metallabscheidung auf dem Transfersubstrat statt. Denn das Transfersubstrat kann mit der Polymerstruktur und in den entsprechenden Komplementärbereichen mit einem elektrisch isolierenden Stoff, insbesondere einem Polymer, bedeckt sein.

Eine Kontaktierung der elektrisch leitenden Oberfläche des Transfersubstrates kann durch laterale Anschlüsse und/oder durch innen angeordnete elektrische Leitungsverbindungen erfolgen. Die elektrisch leitende Oberfläche des Transfersubstrates kann so mit einem Spannungspotenzial verbindbar sein.

Eine weitere bevorzugt Ausgestaltung des Verfahrens zeichnet sich dadurch aus, dass das Transfersubstrat und/oder Substrat elektrisch isolierend ist. Hierbei können die leitfähigen Bereiche durch die leitfähige Polymerstruktur gebildet sein, wobei die Polymerstruktur elektrisch kontaktierbar ist.

Für weitere bevorzugte Ausgestaltungen der Erfindung ist des Weiteren der Gegenstand der deutschen Patentanmeldung DE 10 2009 010 434.8 in vollem Umfang, insbesondere die dort vorteilhaft offenbarten Einzelheiten, Vorteile und Merkmale der Vorrichtung und/oder des Verfahren zur Herstellung von elektrisch leitfähigen Leiterbahnen auf Leiterplatten, auch Gegenstand dieser Patentanmeldung.

### Ausführunasbeispiele:

Weitere Einzelheiten, Vorteile und Merkmale der Erfindung gehen aus der nachfolgenden Beschreibung der Figuren hervor. Dabei zeigen:
- **Figur 1**: einen Ablaufplan mit verschiedenen Ausgestaltungsmöglichkeiten zur Ausführung des erfindungsgemäßen Verfahrens,
- **Figur 2**: eine Schnittansicht einer Strukturelektrode,
- **Figur 3**: eine schematische Darstellung einer Polymerisationsstation zur Durchführung eines Polymerisationsprozesses,
- **Figur 4**: eine Schnittansicht einer Strukturelektrode mit einer Polymerstruktur,
- **Figur 5**: eine Schnittansicht einer Strukturelektrode mit einer Polymerstruktur und einem Transfersubstrat,
- **Figur 6**: eine Schnittansicht einer Strukturelektrode mit einer durch das Transfersubstrat zumindest teilweise abgelösten Polymerstruktur,
- **Figur 7**: eine schematische Darstellung einer Galvanikstation zur Durchführung eines Galvanikprozesses,
- **Figur 8a**: eine Schnittansicht eines Transfersubstrats mit einer Polymerstruktur und einer Metallstruktur,
- **Figur 8b**: eine Schnittansicht einer Strukturelektrode mit einer Polymerstruktur und einer Metallstruktur,
- **Figur 9a**: eine Schnittansicht eines Transfersubstrats mit einer Polymerstruktur und einer Metallstruktur in Verbindung mit einem Substrat,
- **Figur 9b**: eine Schnittansicht einer Strukturelektrode mit einer Polymerstruktur und einer Metallstruktur in Verbindung mit einem Substrat,
- **Figur 10a**: eine Schnittansicht einer Sollbruchstelle durch die Polymerstruktur, die zumindest teilweise mit dem Transfersubstrat verbunden ist,
- **Figur 10b**: eine weitere Schnittstelle einer Sollbruchstelle durch die Polymerstruktur, die zumindest teilweise mit der Strukturelektrode verbunden ist und
- **Figur 11**: eine Schnittansicht einer Metallstruktur auf dem Substrat.

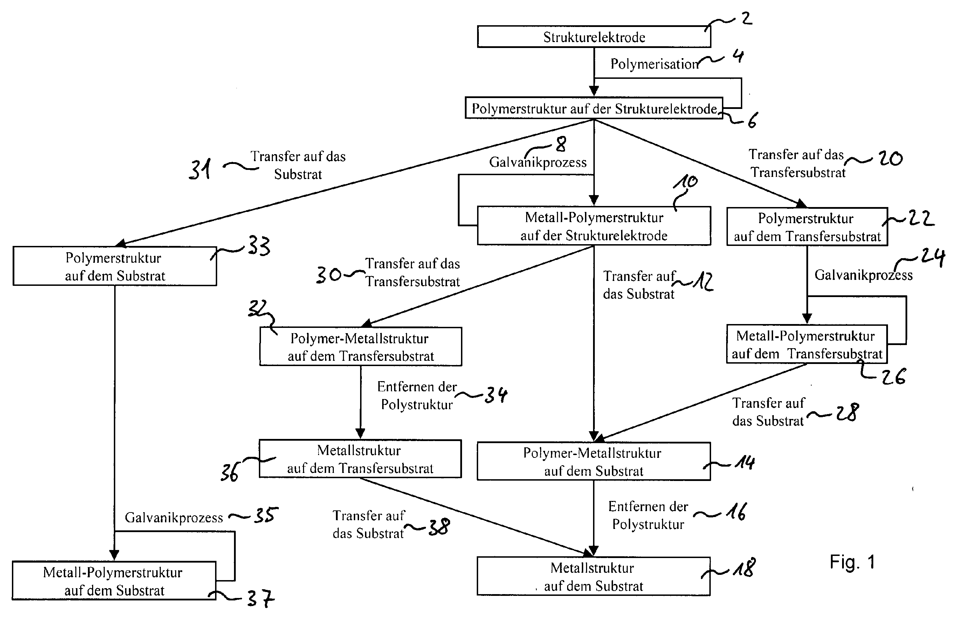

In der Figur 1 ist ein Ablaufplan dargestellt. Dieser umfasst mehrere Wege zur Ausführung des erfindungsgemäßen Verfahrens. Bevor im Weiteren auf diese Wege konkret eingegangen wird, werden zunächst die verwendeten Zeichen zur schematischen Darstellung des Ablaufplans erklärt werden. In einem Rechteck kann ein Ausgangs- oder Zielzustand dargestellt sein. Die Rechtecke sind jeweils durch Pfeile miteinander verbunden. Die Pfeilrichtung zeigt die bevorzugten Zustandsänderungen an. Neben den Pfeilen sind die Operationen dargestellt, durch die die jeweilige Zustandsänderung bewirkt werden kann.

Um das bevorzugte Ziel des erfindungsgemäßen Verfahrens zu erreichen, nämlich eine Metallstruktur auf dem Substrat, wird zunächst von dem Vorhandensein einer Strukturelektrode **2** ausgegangen. Mit Hilfe der Strukturelektrode **2** wird eine Polymerisation **4** ausgeführt. Durch die Polymerisation **4** erfolgt eine elektrochemische Abscheidung eines leitfähigen Polymers auf der Strukturelektrode **2.** Diese Abscheidung erfolgt zumindest im Wesentlichen nur in den Bereichen der vorgebbaren Struktur. Diese vorgebbare Struktur ist der Elektrodenkontaktbereich. Das leitfähige Polymer wird also auf dem Elektrodenkontaktbereich der Strukturelektrode **2** abgeschieden. Somit kann auch von einer Polymerstruktur auf der Strukturelektrode **6** gesprochen werden. Mit der Polymerstruktur auf der Strukturelektrode **6** wird dann ein weiterer Polymerisationsprozess **6,** ein Transfer auf das Substrat **31,** ein Galvanikprozess **8** oder ein Transfer auf ein Transfersubstrat **20** ausgeführt. Ausgehend von der Polymerstruktur auf der Strukturelektrode **6** können also vier alternative Prozessschritte ausgeführt werden. Zunächst wird im Weiteren der Weg beginnend mit dem Galvanikprozess **8** verfolgt. Durch den Galvanikprozess **8** wird ein metallischer Stoff auf der Polymerstruktur abgeschieden. Auf den zu der Polymerstruktur komplementären Bereichen wird kein oder annähernd kein metallischer Stoff abgeschieden. Durch den Polymerisationsprozess **4** und den Galvanikprozess **8** hat die Strukturelektrode **2** Kontakt mit einem Mehrschichtmaterial. Mit anderen Worten ist die Strukturelektrode **2** mit einem Mehrschichtmaterial verbunden. Denn die Strukturelektrode ist zunächst mit der Polymerstruktur verbunden. Auf der von der Strukturelektrode abgewandten Seite ist die Polymerstruktur mit der Metallstruktur verbunden. Somit ist die Metallstruktur zumindest mittelbar auch mit der Strukturelektrode verbunden. Aufgrund der Anordnung der Materialien, nämlich dass die Strukturelektrode zumindest mit der Polymerstruktur verbunden ist und diese wiederum mit der Metallstruktur kann diese Anordnung im Weiteren auch "Metall-Polymerstruktur auf der Strukturelektrode" **10** bezeichnet sein. Die Nomenklatur der Bezeichnung richtet sich an die Anordnung der Stoffe und/oder Schichten, und zwar von außen nach innen. Ausgehend von der Metall-Polymerstruktur auf der Strukturelektrode **10** kann ein Transfer auf das Substrat **12** und/oder ein Transfer auf das Transfersubstrat **30** und/oder ein weiterer Galvanikprozess **8** ausgeführt werden. Der mit der Operation "Transfer auf das Transfersubstrat" **30** beginnende Weg soll in einem später folgenden Abschnitt erläutert werden. Auch der durch den Galvanikprozess **8** gekennzeichnete Weg (der zunächst wieder zu der Metall-Polymerstruktur auf der Strukturelektrode **10** führt) wird in einem später folgenden Abschnitt erläutert. Von der Metall-Polymerstruktur auf der Strukturelektrode **10** wird der Weg beginnend mit "Transfer auf Substrat" **12** weiterverfolgt. Hierbei wird die Metallstruktur und die Polymerstruktur auf das Substrat **14** transferiert. Im einfachsten Fall wird das Substrat auf die Metallstruktur beziehungsweise Metall-Polymerstruktur der Strukturelektrode **10** geklebt. (Von dem Substrat aus betrachtet, kehrt sich somit die Schichtfolge der Metallstruktur und der Substratstruktur um.) Die Metallstruktur ist vorzugsweise direkt mit dem Substrat verbunden. Allenfalls kann zwischen der Metallstruktur und dem Substrat ein Substrathaftmittel angeordnet sein. Auf der dem Substrat abgewandten Seite der Metallstruktur ist die Metallstruktur mit der Polymerstruktur verbunden. Die Polymerstruktur ist zumindest also mittelbar auch mit dem Substrat verbunden. Analog zu der Nomenklatur, die für die Strukturelektrode eingeführt wurde, ist das Substrat mit einer Polymer-Metallstruktur verbunden. Somit kann aus der "Metall-Polymerstruktur auf der Strukturelektrode" **10** durch einen Transfer auf das Substrat **12** eine "Polymer-Metallstruktur auf dem Substrat" **14** entstehen. Durch ein Entfernen der Polymerstruktur **16** von der Polymer-Metallstruktur auf dem Substrat **14** verbleibt sodann die Metallstruktur auf dem Substrat **18.**

Auf dem Weg zu dem im vorangegangenen Absatz verfolgten Ziel wurde an mehreren Abzweigungen jeweils nur ein bestimmter Pfad verfolgt. Es folgt deshalb an dieser Stelle ein Sprung zurück zu der ersten Abzweigung, und zwar zur Polymerstruktur auf der Strukturelektrode **6.**

Die Polymerstruktur auf der Strukturelektrode **6** kann auch durch einen Transfer auf das Transfersubstrat **20** übertragen werden. In einer Ausführungsvariante kann die Polymerstruktur auf das Transfersubstrat mittels eines Transferhaftmittels geklebt werden. Da das Transfersubstrat stärker als die Strukturelektrode an der Polymerstruktur haftet, kann die Polymerstruktur von der Strukturelektrode durch Krafteinwirkung getrennt und/oder abgezogen werden. Dies begünstigt eine nur gering haftende Oberfläche der Strukturelektrode und/oder eine geeignete Stoffzusammensetzung der Polymerstruktur. Mit Hilfe der Polymerstruktur auf dem Transfersubstrat **22** kann ein Galvanikprozess **24** ausgeführt werden. Dabei findet ein Stromfluss durch die Polymerstruktur statt. Die Flächen des Transfersubstrates, die nicht von der Polymerstruktur bedeckt sind, können durch einen, insbesondere zusätzlichen, isolierenden Stoff bedeckt sein. Durch den Galvanikprozess wird nur auf der Polymerstruktur ein metallischer Stoff abgeschieden. Durch den Galvanikprozess **24** ist deshalb danach eine Metall-Polymerstruktur auf dem Transfersubstrat **26.** Diese Nomenklatur wurde analog für die Metall-Polymerstruktur auf der Strukturelektrode **10** eingeführt und auch für die Polymer-Metallstruktur auf dem Substrat verwendet. Eine Metall-Polymerstruktur auf dem Transfersubstrat **26** ist also eine Schichtfolge von Stoffen bzw. Vorrichtungen. Die Polymerstruktur ist hierbei, insbesondere direkt, mit dem Transfersubstrat verbunden. Außerdem kann die Polymerstruktur auf dem von der Transfersubstrat abgewandten Seite mit der Metallstruktur verbunden sein. Dies ist durch die Reihenfolge - Polymerisation **4** gefolgt von dem Galvanikprozesses **24 -** bedingt. Ausgehend von der Metall-Polymerstruktur auf dem Transfersubstrat **26** kann ein Galvanikprozess **24,** der wieder zu der Metall-Polymerstruktur auf dem Transfersubstrat **26** führt, ausgeführt werden oder ein Transfer auf das Substrat **28** erfolgen. Der Galvanikprozess **24** soll mit in einem später folgenden Abschnitt erläutert werden. Zunächst wird auf den "Transfer auf das Substrat" **28** eingegangen. Denn durch den Transfer auf das Substrat **28** kann die Metallstruktur und die Polymerstruktur des Transfersubstrats auf das Substrat übertragen werden. Hierbei kann die Metallstruktur mit dem Substrat in Verbindung gebracht werden. Besonders eignet sich hierfür eine Klebeverbindung. Ferner haftet das Transfersubstrat nicht so stark an der Polymerstruktur, wie die Metallstruktur und/oder das Transferhaftmittel an dem Substrat. Deshalb kann die Polymerstruktur zumindest in Teilen von dem Substrat abgetrennt und/oder abgezogen werden. Hierbei ist es durchaus möglich, dass die Polymerstruktur zerbricht und/oder zerstört wird. Sie kann deshalb als Sollbruchstelle wirken. Auf dem Substrat verbleibt die Metallstruktur und zumindest ein Teil der Polymerstruktur. Somit entsteht also auch eine Polymer-Metallstruktur auf dem Substrat **14.**

Zwei Abzweigungen wurden in dem vorvorletzten Absatz eingeführt. Auf den alternativen Pfad, ausgehend von der ersten dieser zwei Abzweigungen nimmt der vorgestellte Absatz Bezug. Es folgt deshalb an dieser Stelle ein Sprung zurück zu der zweiten Abzweigung (aus dem vorvorletzten Absatz), und zwar zur Metall-Polymerstruktur auf der Strukturelektrode **10.**

Die Metall-Polymerstruktur auf der Strukturelektrode **10** wird durch einen Transfer auf das Transfersubstrat **30** übertragen. Bevorzugt wird das Transfersubstrat auf die Metallstruktur geklebt und danach das Transfersubstrat gemeinsam mit der Metallstruktur von der Strukturelektrode bzw. von der Polymerstruktur getrennt und/oder abgezogen. Dabei kann die Polymerstruktur zerbrechen und/oder in mehrere Teile aufgebrochen werden. Die Polymerstruktur kann dabei also als Sollbruchstelle wirken. Nach dem Transfer der Metall-Polymerstruktur auf das Transfersubstrat entsteht also eine Polymer-Metallstruktur auf dem Transfersubstrat **32.** Die Polymerstruktur kann hierbei aus Teilen der ursprünglich abgeschiedenen Polymerstruktur bestehen. Diese Polymerstruktur kann beispielsweise chemisch und/oder mechanisch entfernt werden. Durch ein Entfernen der Polymerstruktur **34** verbleibt also die Metallstruktur auf dem Transfersubstrat **36.** Daraufhin kann ein Transfer auf das Substrat **38** erfolgen. Hierbei wird die Metallstruktur mit dem Substrat in Verbindung gebracht. Insbesondere kann die Metallstruktur durch ein Substrathaftmittel mit dem Substrat verbunden werden. Das Transfersubstrat kann danach abgetrennt und/oder entfernt werden. Dies kann chemisch oder mechanisch erfolgen. Insbesondere kann das Transfersubstrat durch ein an das Transfersubstrat angepasstes Lösungsmittel von der Metallstruktur und/oder von dem Substrat gelöst werden. Nach dem Transfer ist die Metallstruktur auf dem Substrat.

Auf dem Weg zu dem in den vorangegangenen Absätzen verfolgten Ziel wurde an mehreren Abzweigungen jeweils nur bestimmte Pfade verfolgt. Es verbleibt jedoch noch ein Pfad, und zwar wieder ausgehend von der Polymerstruktur auf der Strukturelektrode **6.**

Die Polymerstruktur auf der Strukturelektrode **6** kann auch durch einen Transfer auf das Substrat **31** übertragen werden. In einer Ausführungsvariante kann die Polymerstruktur auf das Substrat mittels eines Substrathaftmittels geklebt werden. Da das Substrat stärker als die Strukturelektrode an der Polymerstruktur haftet, kann die Polymerstruktur von der Strukturelektrode durch Krafteinwirkung getrennt und/oder abgezogen werden. Dies begünstigt eine nur gering haftende Oberfläche der Strukturelektrode und/oder eine geeignete Stoffzusammensetzung der Polymerstruktur. Mit Hilfe der Polymerstruktur auf dem Substrat **33** kann ein Galvanikprozess **35** ausgeführt werden. Dabei findet ein Stromfluss durch die Polymerstruktur statt. Die Flächen des Substrates, die nicht von der Polymerstruktur bedeckt sind, können durch einen, insbesondere zusätzlichen, isolierenden Stoff bedeckt sein. Durch den Galvanikprozess wird nur auf der Polymerstruktur ein metallischer Stoff abgeschieden. Durch den Galvanikprozess **35** ist deshalb danach eine Metall-Polymerstruktur auf dem Substrat **37.** Diese Nomenklatur wurde analog für die Metall-Polymerstruktur auf der Strukturelektrode **10** eingeführt und auch für die Polymer-Metallstruktur auf dem Substrat verwendet. Eine Metall-Polymerstruktur auf dem Substrat **37** ist also eine Schichtfolge von Stoffen bzw. Vorrichtungen. Die Polymerstruktur ist hierbei, insbesondere direkt, mit dem Substrat verbunden. Außerdem kann die Polymerstruktur auf dem von der Transfersubstrat abgewandten Seite mit der Metallstruktur verbunden sein. Dies ist durch die Reihenfolge - Polymerisation **4** gefolgt von dem Galvanikprozesses **24 -** bedingt. Die Polymerstruktur kann somit auch als Haftvermittlungsschicht wirken.

Im Weiteren wird auf den Galvanikprozess **8, 35** und/oder **24** eingegangen. Diesen Galvanikprozessen **8, 24, 35** liegt der gleiche Gedanke zu Grunde. Denn die Metall-Polymerstruktur auf der Strukturelektrode **10,** die Metall-Polymerstruktur auf dem Transfersubstrat **26** oder die Metall-Polymerstruktur auf dem Substrat **37** werden durch einen Galvanikprozess **8, 24** bzw. **35** hergestellt. Ein weiterer anschließender Galvanikprozess **8, 24, 35** ist deshalb grundsätzlich möglich. Hierbei kann es bevorzugt sein, dass ein zu dem zuvor verwendeten metallischen Stoff verschiedener metallischer Stoff für den nachfolgenden Galvanikprozess **8, 24, 35** verwendet wird. So kann ein metallischer Stoff eines ersten Galvanikprozesses beispielsweise Kupfer sein oder aufweisen. Ist es beabsichtigt, dass die Metallstruktur von sehr hohen Strömen durchflossen werden soll, kann es sinnvoll sein, dass die äußerste Metallschicht einen hochleitfähigen metallischen Stoff, beziehungsweise Nickel, aufweist. Dies ist dann bei dem entsprechenden Galvanikprozess **8, 24, 35** zu berücksichtigen.

Ein analoger Sachverhalt gilt für die Polymerisation 4, die mehrfach nacheinander ausgeführt werden kann. Hierbei kann es bevorzugt sein, dass eine zu der zuvor verwendeten, polymerisier- und/oder vernetzbaren Verbindung verschiedene, polymerisier- und/oder vernetzbare Verbindung für den nachfolgenden Polymerisationsprozess **6** verwendet wird.

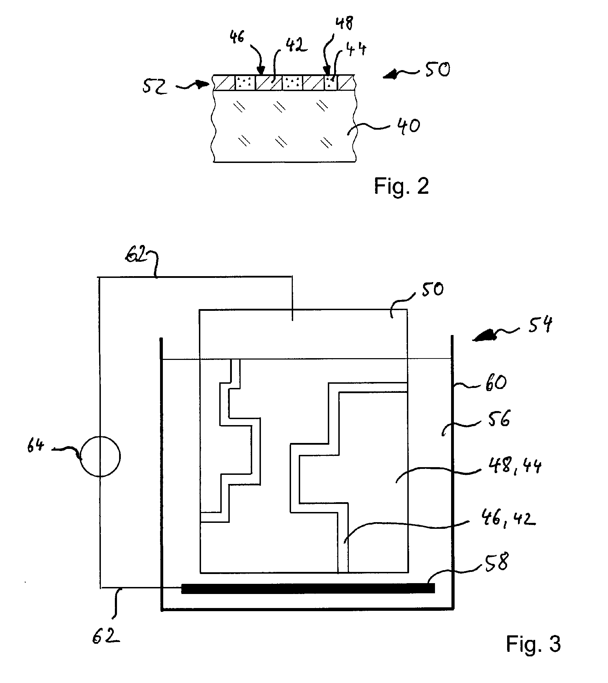

In Figur 2 ist eine Schnittansicht einer Strukturelektrode **50** dargestellt. Die Strukturelektrode **50** weist ein Trägermaterial **40** auf. Auf das Trägermaterial **40** ist eine Funktionsträgerschicht **52** aufgebracht. Die Funktionsträgerschicht **52** weist leitfähige Elektrodenoberflächenschichten **42** und nicht leitfähige Elektrodenoberflächenschichten **44** auf. Die von dem Trägermaterial **40** wegweisende Oberfläche der leitfähigen Elektrodenoberflächenschichten **42** ist der Elektrodenkontaktbereich **46.** Die von dem Trägermaterial **40** wegweisende Oberfläche der nicht leitfähigen Elektrodenoberflächenschichten **44** ist der Elektrodenkomplementärbereich **48.** Der Elektrodenkontaktbereich **46** und der Elektrodenkomplementärbereich **48** können jeweils aus einzelnen Teiloberflächen der Strukturelektrode sein.

In einer weniger bevorzugten Ausführungsform ist die Trägerschicht **40** aus Glas, die leitfähigen Elektrodenoberflächenschichten **42** aus Indium-Zinn-Oxid und die nicht leitfähigen Elektrodenoberflächenschichten **44** aus einem isolierenden Stoff, insbesondere einem isolierenden Polymer.

In einer alternativen und bevorzugten Ausführungsform ist die Trägerschicht 40 elektrisch leitfähig, um alle leitfähigen Elektrodenoberflächenschichten 42 und/oder Elektrodenkontaktbereiche 46 elektrisch zu verbinden. Die leitfähigen Elektrodenoberflächenschichten 42 können aus einem anderen Material als das Trägermaterial 40 bestehen. Beispielsweise kann das Trägermaterial 40 ein Si-Wafer sein, wobei Silizium das leitfähige Trägermaterial. Die leitfähigen Elektrodenoberflächenschichten 42 können aus Cr/Au sein oder dieses aufweisen. Außerdem können die nichtleitfähigen Elektrodenoberflächenschichten 44 aus SiO₂ bestehen oder diese aufweisen.

In Figur 3 ist eine schematische Darstellung einer Polymerisationsstation **54** zur Durchführung eines Polymerisationsprozesses gezeigt. Die Strukturelektrode **50** ist zumindest teilweise in den ersten Elektrolyten **56** eingetaucht und/oder in Kontakt mit diesem gebracht. Der erste Elektrolyt **56** kann hierbei von einem Behälter **60** aufgenommen sein. Die Strukturelektrode **50** ist zumindest soweit mit dem ersten Elektrolyten **56** in Kontakt gebracht, dass zumindest auch Teile des Elektrodenkontaktbereiches **46** und des Elektrodenkomplementärbereiches **48** der Strukturelektrode **50** mit dem ersten Elektrolyten **56** in Kontakt gebracht sind. Außerdem ist eine Gegenelektrode **58** mit dem ersten Elektrolyten **56** in Kontakt gebracht. Die Strukturelektrode **50** und die Gegenelektrode **58** sind durch elektrische Leitungsverbindungen **62** mit einer Spannungsquelle **60** verbunden. Mit der Polymerisationsstation **54** wird durch eine elektrochemische Polymerisation ein elektrisch leitfähiges Polymer auf dem Elektrodenkontaktbereich **46** abgeschieden. Dazu wird eine Spannung zwischen der Strukturelektrode **50** und der Gegenelektrode **58** angelegt.

So kann für ein Ausführungsbeispiel eine Polymerstruktur aus einem dotiertem Poly(3-Methylthiophen) hergestellt werden. Dabei besteht der erste Elektrolyt aus einer Lösung von 0,03 Et₄NBF₄ in trockenem Propylencarbonat. Für den Polymerisationsprozess ist die Strukturelektrode **50** die Anode und die Gegenelektrode **58** die Kathode. Die Gegenelektrode kann Platin aufweisen oder aus Platin sein. Beim Einschalten der Spannungsquelle **60** wird eine Spannung von beispielsweise 10 Volt zwischen der Strukturelektrode **50** und der Gegenelektrode **58** angelegt. Auf dem Elektrodenkontaktbereich **46** der Strukturelektrode **50** findet eine elektrochemische Polymerisation statt. Dabei scheidet sich ein leitfähiger Polymerfilm aus dotiertem Poly(3-Methylthiophen) mit einer Struktur entsprechend der vorgebbaren Struktur ab. Sobald der abgeschiedene Polymerfilm bzw. die Polymerstruktur die gewünschte Dicke von hier 0,5 mm aufweist (ca. nach 30 Sekunden), kann die Spannung abgeschaltet werden. Danach kann die Strukturelektrode **50** aus dem ersten Elektrolyten **56** herausgeholt werden. Die Strukturelektrode 50 mit dem auf ihrem Elektrodenkontaktbereich **46** gebildeten Polymerfilm (Polymerstruktur) **46** kann dann für weitere Verfahrensschritte verwendet werden.

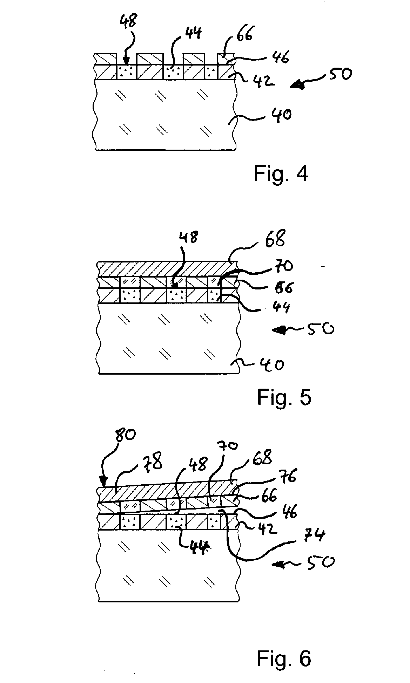

In Figur 4 ist der auf dem Elektrodenkontaktbereich **46** der Strukturelektrode **50** abgeschiedene Polymerfilm **66** dargestellt. Da der Elektrodenkontaktbereich 46 die vorgebbare Struktur aufweist, hat auch der abgeschiedene leitfähige Polymerfilm, also die Polymerstruktur **66,** nahezu die vorgegebene Struktur. Denn der bei der Polymerisation fließende Strom fließt nur im Bereich des Elektrodenkontaktbereiches **46.** Es fließt kein Strom durch die nicht leitfähige Elektrodenoberflächenschicht **44** und/oder auch kein Strom im Elektrodenkomplementärbereich **48.** Im Elektrodenkomplementärbereich **48** findet deshalb auch keine elektrochemische Polymerisation statt. Deshalb wird hier auch kein Polymer aus dem ersten Elektrolyten abgeschieden. Die Struktur des Elektrodenkontaktbereiches **46** bestimmt deshalb auch die Struktur der Polymerstruktur **66** unter Berücksichtigung isotropen Schichtwachstums.

In Figur 5 ist eine Schnittansicht einer Strukturelektrode **50** mit einer Polymerstruktur **66** und einem Transfersubstrat **68** gezeigt. Dabei kann die Verbindung zwischen der Polymerstruktur **66** und dem Transfersubstrat **68** durch ein Transferhaftmittel **70** hergestellt sein. Das Transferhaftmittel **70** kann vor dem in Kontakt bringen des Transfersubstrates **68** mit der Polymerstruktur **66** auf die Polymerstruktur **66** aufgebracht sein. Nach dem in Kontakt bringen des Transfersubstrats **68** mit der Polymerstruktur **66** härtet das Transferhaftmittel **70** aus. Dadurch entsteht eine kraft- und/oder stoffschlüssige Verbindung zwischen dem Transfersubstrat **68** und der Polymerstruktur **66.** Ferner kann das Transferhaftmittel eine chemische Bindung mit der Polymerstruktur **66** und/oder dem Transfersubstrat **68** aufweisen. Das Transferhaftmittel **70** haftet an der nicht leitfähigen Elektrodenoberflächenschicht **44** der Strukturelektrode **50** und/oder an dem Elektrodenkomplementärbereich **48** deutlich geringer als an dem Transfersubstrat **68** und/oder an der Polymerstruktur **66.** Es ist deshalb möglich, dass die Polymerstruktur **66** von der Strukturelektrode **50,** insbesondere durch Krafteinwirkung, getrennt und/oder abgezogen wird.

In Figur 6 ist eine Schnittansicht einer Strukturelektrode **50** mit einer durch das Transfersubstrat **68** zumindest teilweise abgelösten Polymerstruktur **66** gezeigt. In dieser Ausgestaltung haftet die Polymerstruktur **66** stärker an dem Transfersubstrat **68** und/oder an dem Transferhaftmittel **70** als an der leitfähigen Elektrodenoberflächenschicht **42** der Strukturelektrode **50** und/oder als an dem Elektrodenkontaktbereich **46** der Strukturelektrode **50.** Die Polymerstruktur **66** kann somit durch das Transfersubstrat **68** von der Strukturelektrode **50** abgezogen oder getrennt werden. Sofern das Trennen und/oder Abziehen seitlich angefangen und/oder sich über die laterale Fläche der Strukturelektrode **50** erstreckend fortlaufend ausgeführt wird, kann sich ein Trennungsbereich **74** bilden. Dieser Trennungsbereich **74** kann keilförmig sein. Auf diese Weise erfolgt ein Transfer der Polymerstruktur **66** von der Strukturelektrode 50 auf das Transfersubstrat **68.**

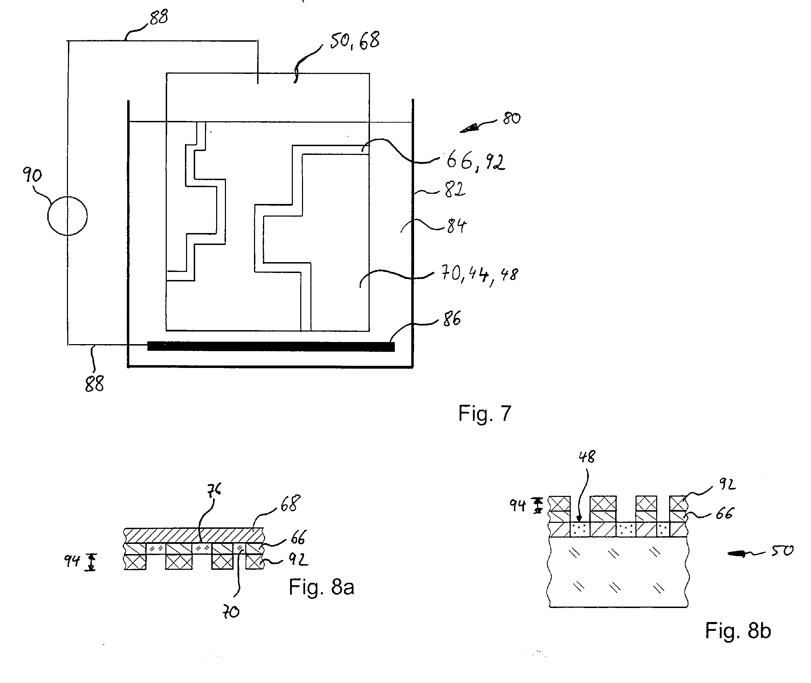

In Figur 7 ist eine schematische Darstellung einer Galvanikstation **80** zur Durchführung eines Galvanikprozesses gezeigt. Die Galvanikstation **80** weist einen Behälter **82** auf. In diesem Behälter **82** ist das zweite Elektrolyt **84** eingebracht. Das Elektrolyt weist Kupfer auf. In diesem Sinne kann es ein Metallsalz, insbesondere Kupfersulfat (CuSO₄), aufweisen. Außerdem ist eine Gegenelektrode **86,** die beispielsweise auch aus Kupfer ist und/oder Kupfer aufweist, in den Behälter **82** eingebracht und/oder mit dem zweiten Elektrolyten **84** in Kontakt gebracht. Außerdem ist die Polymerstruktur **66** mit dem zweiten Elektrolyten **84** in Kontakt gebracht. Die Polymerstruktur kann dabei mit der Strukturelektrode **50** oder mit dem Transfersubstrat **68** verbunden sein. Sofern die Polymerstruktur **66** mit der Strukturelektrode **50** verbunden ist, kann auch die Strukturelektrode zumindest teilweise mit dem zweiten Elektrolyten **84** in Kontakt gebracht sein. Die Strukturelektrode **50** weist wie bereits zu *Figur 4* und *Figur 2* erläutert eine nicht leitfähige Elektrodenoberflächenschicht **44** und/oder einen Elektrodenkomplementärbereich **48** auf. In dem Elektrodenkomplementärbereich **48** der Strukturelektrode **50** wird durch den Galvanikprozess kein bzw. im Wesentlichen kein Metall abgeschieden. Die Abscheidung des Metalls erfolgt auf der Polymerstruktur **66.** Durch die Metallabscheidung entsteht auf der Polymerstruktur **66** eine Metallstruktur **92.**

Sofern nicht die Strukturelektrode **50,** sondern das Transfersubstrat **68** für den Polymerisations-Prozess verwendet wird, kann auch das Transfersubstrat **68** zumindest teilweise mit dem zweiten Elektrolyten **84** in Kontakt gebracht sein. Mit dem Transfersubstrat **68** in Verbindung steht die Polymerstruktur **66.** Ferner weist das Transfersubstrat **68** einen nicht leitfähigen Bereich **70** auf. Der nicht leitfähige Bereich kann komplementär zu der Polymerstruktur **66** sein. In dem vorliegenden Fall ist dieser nicht leitfähige Bereich **70** des Transfersubstrats **68** von dem, insbesondere nicht leitfähigen, Transferhaftmittel bedeckt. Durch den Polymerisations-Prozess erfolgt eine Abscheidung des metallischen Stoffes aus dem zweiten Elektrolyten **84** auf die Polymerstruktur **66.** Auf dem nicht leitfähigen Bereich **70** des Transfersubstrats **68** wird kein oder im Wesentlichen kein metallischer Stoff abgeschieden.

Grundsätzlich kann die Abscheidung des metallischen Stoffes durch das Ein- oder Ausschalten der Spannungsquelle **90** gesteuert werden. Denn sowohl die Gegenelektrode **86** als auch die Polymerstruktur sind jeweils über elektrische Verbindungsleitungen **88** mit der Spannungsquelle **90** verbunden. Eine Abscheidung findet also nur statt, wenn die Spannungsquelle eingeschaltet ist und/oder eine Spannungsdifferenz zwischen der Gegenelektrode und der Polymerstruktur hergestellt ist.

Zusammenfassend kann also die galvanische Abscheidung des metallischen Stoffes aus dem zweiten Elektrolyten **84** auf der Polymerstruktur **66** erfolgen, wobei die Polymerstruktur **66** mit der Strukturelektrode **50** und/oder mit dem Transfersubstrat **68** verbunden ist.

In den folgenden Figuren beziehen sich diejenigen Figuren mit dem Endbuchstaben "a" auf den Galvanikprozess der mit dem Transfersubstrat **68** durchgeführt wurde. Diejenigen Figuren mit dem Endbuchstaben "b" beziehen sich auf den Galvanikprozess, der mit der Strukturelektrode **50** durchgeführt wurde.

In Figur 8a ist eine Schnittansicht eines Transfersubstrats **68** mit einer Polymerstruktur **66** und einer Metallstruktur **92** gezeigt. Die Metallstruktur 92 ist nur oder im Wesentlichen nur mit der Polymerstruktur **66** verbunden. Lateral erstreckt sich die Metallstruktur **92** zumindest im Wesentlichen nicht über die von dem Transfersubstrat **68** abgewandten Oberfläche der Polymerstruktur **66** hinaus. Insbesondere in Abhängigkeit der Spannung und/oder der Dauer des Galvanikprozesses weist die Metallstruktur **92** eine bestimmte Dicke **94** auf. Dadurch, dass die metallische Abscheidung zumindest im Wesentlichen nur auf der Polymerstruktur **66** erfolgt, prägt die Struktur der Polymerstruktur **66** auch die Struktur der Metallstruktur **92.** Die Strukturen sind vorzugsweise im Wesentlichen gleich, insbesondere auf ihre Dicke. Die Strukturen entsprechen vorzugsweise auch der vorgebbaren Struktur der Strukturelektrode. Auf dem Transferhaftmittel **70** wurde kein Metall durch den Galvanikprozess abgeschieden.

In Figur 8b ist eine Schnittansicht einer Strukturelektrode **50** mit einer Polymerstruktur **66** und einer Metallstruktur **92** gezeigt. Durch den Galvanikprozess wurde der metallische Stoff nur auf der Polymerstruktur **66** abgeschieden. Die Metallstruktur **92** erstreckt sich deshalb nicht oder im Wesentlichen nicht lateral über die Polymerstruktur **66** hinaus. In Abhängigkeit der Spannung und der Dauer des Anlegens der Spannung bei dem Galvanikprozess weist die Metallstruktur **92** eine bestimmte Dicke **94** auf. Auf dem Elektrodenkomplementärbereich **48** der Strukturelektrode **50** ist zumindest durch die elektrochemische Galvanisierung kein Metall abgeschieden worden. Die Struktur der Polymerstruktur **66** prägt deshalb die Struktur der Metallstruktur **92.** Die beiden Strukturen sind zumindest im Wesentlichen der vorgebbaren Struktur der Strukturelektrode **50** gleich.

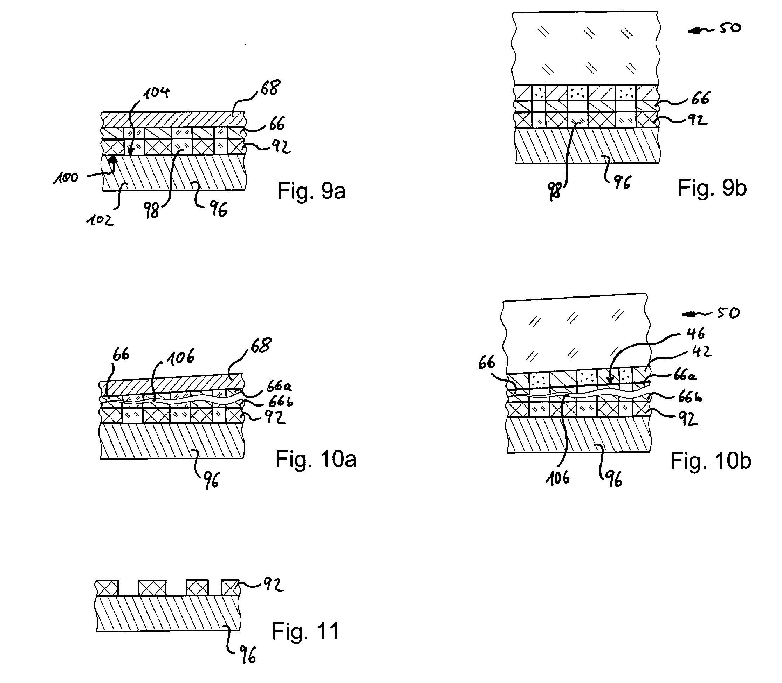

In Figur 9a ist eine Schnittansicht eines Transfersubstrats **68** mit einer Polymerstruktur **66** und einer Metallstruktur **92** in Verbindung mit einem Substrat **96** gezeigt. Die Metallstruktur **92** ist auf der von der Polymerstruktur **66** und/oder dem Transfersubstrat **68** abgewandten Seite **100** mit dem Substrat **96** verbunden. Vor dem in Kontakt bringen des Substrates **96** mit der Metallstruktur **92** wurde auf das Substrat, die Metallstruktur **92** und/oder in dessen Zwischenbereiche **98** ein Substrathaftmittel auf- bzw. eingebracht. Das Substrathaftmittel haftet sowohl an dem Substrat **96** als auch an der Metallstruktur **92.** Das Substrat **96** ist elektrisch isolierend. Insbesondere weist es ein elektrisch isolierendes Trägermaterial **102** auf.

In Figur 9b ist eine Schnittansicht einer Strukturelektrode **50** mit einer Polymerstruktur **66** und einer Metallstruktur **92** in Verbindung mit einem Substrat **96** gezeigt. Der Kontaktbereich zwischen der Metallstruktur **92** und dem Substrat **96** ist analog zu dem Kontaktbereich aus Figur 9a ausgestaltet. Auch hier ist das Substrat **96** durch ein Substrathaftmittel **98** mit der Metallstruktur verbunden. Das Substrathaftmittel **98** verbindet aber nicht die Polymerstruktur **66** mit der Metallstruktur **92** und/oder mit dem Substrat **96.** Die zu Figur 9a eingeführten Vorteile, Merkmale und/oder Eigenschaften des Substrats **96,** des Transferhaftmittels **98,** der Metallstruktur **92** und den weiteren Kontakt- und/oder Kontaktbereich zwischen der Metallstruktur **92** und dem Substrat betreffend gelten hier analog.

In Figur 10a ist eine Schnittansicht einer Sollbruchstelle **106** durch die Polymerstruktur **66,** die zumindest teilweise mit den Transfersubstrat **68** verbunden ist. Ob nun durch eine zumindest im Wesentlichen normale, nach außen gerichtete Krafteinwirkung auf das Transfersubstrat **68** und das Substrat, oder durch eine anders gerichtete Krafteinwirkung, beispielsweise einer schräg nach außen gerichteten Abziehkraft, verursacht, kann die Polymerstruktur **66** als Sollbruchstelle und/oder als Sollbruchschicht wirken. Die Polymerstruktur **66** und/oder das Transferhaftmittel **70** weisen dazu insbesondere jeweils eine geringere Festigkeit, insbesondere eine geringere spezifische Festigkeit, als die Metallstruktur **92,** das Substrat **96,** das Transferhaftmittel und/oder das Transfersubstrat **68** auf. Die Festigkeit und/oder spezifische Festigkeit kann auch die Bruchfestigkeit sein. Bei einer der zuvor genannten Krafteinwirkungen kann deshalb die Polymerstruktur wie in Figur 10a dargestellt winkelig aufbrechen. Die Polymerstruktur 66 kann dabei in mehrere Teile zerbrechen und/oder geteilt werden. So können Teile der Polymerstruktur **66** an dem Transfersubstrat **68** haften bleiben. Die an dem Transfersubstrat **68** haften bleibenden Teile der Polymerstruktur werden dann von den Teilen der Polymerstruktur **66,** die an der Metallstruktur **92** haften bleiben, getrennt.

Alternativ (nicht dargestellt) kann die Polymerstruktur **66** auch mit dem Transfersubstrat **68** von der Metallstruktur **92,** insbesondere im Wesentlichen vollständig, getrennt werden. Dazu kann die Verbindung zwischen der Polymerstruktur **66** und der Metallstruktur **92** in der Weise ausgestaltet sein, dass es zur Trennung der beiden Strukturen der Krafteinwirkung bedarf, die nicht ausreicht, um die Polymerstruktur **66** zu zerstören, zu zerbrechen und/oder zu zerreißen. Mit anderen Worten ist dazu die Bruchfestigkeit der Polymerstruktur **66** höher als die Festigkeit der Verbindung zwischen der Polymerstruktur **66** und der Metallstruktur **92.** Die Bruchfestigkeit der Polymerstruktur und/oder die Festigkeit der Verbindung zwischen der Polymerstruktur und der Metallstruktur kann durch eine geeignete Wahl des Lösungsmittels des ersten Elektrolyten und/oder durch eine geeignete Wahl der polymerisier- und/oder verletzbaren Verbindungen des ersten Elektrolyten vorteilhaft bestimmt werden.

In Figur 10b ist eine weitere Schnittansicht einer Sollbruchstelle **106** durch die Polymerstruktur **66** gezeigt, die zumindest teilweise mit der Strukturelektrode **50** verbunden ist. Durch nach außen gerichtete Krafteinwirkungen auf die Strukturelektrode **50** und das Substrat **96** kann die Polymerstruktur in einen ersten Teil **66a** und in einen zweiten Teil **66b** zerbrechen und/oder getrennt werden. Die Krafteinwirkungen können insbesondere analog zu denen aus Figur 10a zumindest im Wesentlichen normal nach außen und/oder in einer anderen Kraftrichtung auf die Strukturelektrode **50** und das Substrat **96** wirken. Die Polymerstruktur **66** weist eine geringere Festigkeit, insbesondere Bruchfestigkeit, als die Strukturelektrode **50,** insbesondere dessen leitfähige Elektrodenoberflächenschicht **42** und/oder dessen Elektrodenkontaktbereich **46,** die Metallstruktur **92,** das Transferhaftmittel **98** und/oder das Substrat **96** auf.

In Figur 11 ist eine Schnittansicht einer Metallstruktur **92** auf einem Substrat **96** dargestellt. Das zuvor in Figur 10a oder in Figur 10b noch mit der Metallstruktur **92** verbundene Polymer, insbesondere die Polymerstruktur **66** bzw. ein Teil der Polymerstruktur **66b** wurde thermisch, chemisch und/oder mechanisch von der Metallstruktur **99** entfernt. Auch das Transferhaftmittel kann zumindest teilweise entfernt sein. Dazu eignen sich ebenfalls mechanische, thermische und/oder chemische Methoden. Dargestellt sind in Figur 11 deshalb die wesentlichen Elemente, nämlich die Metallstruktur **92** auf dem Substrat **96.**

## Patentansprüche

1. Verfahren zur Herstellung einer Metallstruktur auf einem Substrat, **gekennzeichnet durch** die Verfahrensschritte:
a. einen Polymerisationsprozess, wobei mindestens eine Strukturelektrode verwendet wird, deren Oberfläche einen ersten Bereich einer vorgebbaren Struktur (Elektrodenkontaktbereich) und einen übrigen, zweiten Bereich (Elektrodenkomplementärbereich) aufweist, wobei der Elektrodenkontaktbereich mit einem ersten Spannungspotential verbindbar ist, wenigstens ein Teil des Elektrodenkontaktbereiches in Kontakt mit einem, vorzugsweise flüssigen, ersten Elektrolyten gebracht wird, wobei in den ersten Elektrolyten polymerisier- und/oder vernetzbare Verbindungen eingebracht sind, und über die Strukturelektrode ein erster Stromfluss **durch** den ersten Elektrolyten erzeugt wird, wobei auf den mit dem ersten Elektrolyten in Kontakt gebrachten Elektrodenkontaktbereich ein leitfähiger Polymerfilm der vorgegebenen Struktur gebildet wird (Polymerstruktur),
b. einen Galvanikprozess, wobei wenigstens ein Teil der Polymerstruktur in Kontakt mit einem, vorzugsweise flüssigen, zweiten Elektrolyten gebracht wird, wobei in den zweiten Elektrolyten ein metallischer Stoff eingebracht ist, wobei über die Polymerstruktur ein zweiter Stromfluss **durch** den zweiten Elektrolyten erzeugt wird, wobei auf den mit dem zweiten Elektrolyten in Kontakt gebrachten Bereich der Polymerstruktur ein leitfähiger Metallfilm der vorgegebenen Struktur gebildet und/oder abgeschieden wird (Metallstruktur),
c. einen Transfer der Metallstruktur auf das Substrat, wobei wenigstens ein Teil der Metallstruktur auf das Substrat aufgebracht wird, und/oder einen Transfer der Polymerstruktur auf das Substrat, wobei wenigstens ein Teil der Polymerstruktur auf das Substrat aufgebracht wird.

2. Verfahren nach dem vorhergehenden Anspruch, **dadurch gekennzeichnet, dass** das Substrat eine Leiterplatte ist.

3. Verfahren nach einem der vorhergehenden Ansprüche, **dadurch gekennzeichnet, dass** die auf das Substrat aufgebrachte Metall- und/oder Polymerstruktur durch ein Haftmittel (Substrathaftmittel) und/oder durch ein insbesondere thermisches Fügeverfahren, insbesondere Löten, Schweißen, Laminieren und/oder Ultraschallfügen, mit dem Substrat, vorzugsweise stoffschlüssig, verbunden wird.

4. Verfahren nach einem der vorhergehenden Ansprüche, **dadurch gekennzeichnet, dass** das Substrathaftmittel derart gewählt wird, dass eine Haftung zwischen Elektrode und Polymerstruktur schwächer ist als eine Haftung zwischen Substrathaftmittel und Metallstruktur, Substrat und/oder Polymerstruktur.

5. Verfahren nach einem der vorhergehenden Ansprüche, **gekennzeichnet durch** einen Transfer wenigstens eines Teils der Polymerstruktur und/oder wenigstens eines Teils der Metallstruktur auf ein Transfersubstrat, wobei wenigstens ein Teil der Polymerstruktur und/oder der Metallstruktur mit dem Transfersubstrat in Verbindung gebracht wird.

6. Verfahren nach einem der vorhergehenden Ansprüche, **dadurch gekennzeichnet, dass** zur Bildung des Transfersubstrats ein Fluid ausgehärtet wird.

7. Verfahren nach dem vorhergehenden Anspruch, **dadurch gekennzeichnet, dass** das Fluid durch Entziehen eines Lösungsmittels, Beleuchten mit UV-Strahlung und/oder Beifügen eines Härters ausgehärtet wird.

8. Verfahren nach einem der vorhergehenden Ansprüche, **dadurch gekennzeichnet, dass** das die Elektrode wieder verwendbar ist.

9. Verfahren nach einem der vorhergehenden Ansprüche, **dadurch gekennzeichnet, dass** wenigstens ein Teil der an dem Transfersubstrat haftende Polymerstruktur und/oder Metallstruktur, insbesondere zerstörungsfrei, von der Strukturelektrode abgezogen wird.

10. Verfahren nach einem der vorhergehenden Ansprüche, **dadurch gekennzeichnet, dass** die Metallstruktur und/oder das mit der Metallstruktur verbundene Substrat von zumindest einem Teil der leitfähigen Polymerstruktur getrennt wird, und zwar insbesondere durch ein Lösen und/oder Ätzen zumindest eines Teils der Polymerstruktur durch ein, vorzugsweise flüssiges und/oder vorzugsweise die Polymerstruktur lösendes, Lösungsmittel, das die Metallstruktur insbesondere im Wesentlichen nicht löst und/oder ätzt, und/oder insbesondere durch ein Verflüssigen der Polymerstruktur durch eine Energie-und/oder Wärmezufuhr, wobei die Polymerstruktur einen niedrigeren Schmelzpunkt als die Metallstruktur aufweist und/oder insbesondere durch eine Überführung der Polymerstruktur in den Gaszustand durch eine Energie-und/oder Wärmezufuhr, wobei die Vergasungstemperatur der Polymerstruktur niedriger als die Schmelztemperatur der Metallstruktur ist, und/oder insbesondere durch ein mechanisches Abtrennen, beispielsweise durch ein Wasserstrahl-, Luftstrahl, Rakel-, Sandstrahl- und/oder Schleifverfahren.

11. Verfahren nach einem der vorhergehenden Ansprüche, **dadurch gekennzeichnet, dass** die Polymerstruktur eine geringere Zug- und/oder Bruchfestigkeit als die Strukturelektrode, die Strukturelektrodenoberfläche, die Metallstruktur, das Substrathaftmittel, das Transferhaftmittel, das Transfersubstrat und/oder das Substrat aufweist.

12. Verfahren nach einem der vorhergehenden Ansprüche, **dadurch gekennzeichnet, dass** das Substrathaftmittel und das Transferhaftmittel unterschiedliche Schmelzpunkte (bzw. -temperaturen) aufweisen und/oder das Transferhaftmittel einen, insbesondere deutlich, niedrigeren Schmelzpunkt als das Substrathaftmittel aufweist.

13. Verfahren nach einem der vorhergehenden Ansprüche, **dadurch gekennzeichnet, dass** das Substrathaftmittel und das Transferhaftmittel unterschiedliche Sublimationspunkte aufweisen und/oder das Transferhaftmittel einen, insbesondere deutlich, niedrigeren Sublimationspunkt als das Substrathaftmittel aufweist.

14. Verfahren nach einem der vorhergehenden Ansprüche, **dadurch gekennzeichnet, dass** die in den ersten Elektrolyten eingebrachten Verbindungen, wenigstens teilweise, niedermolekulare Verbindungen, vorzugsweise Monomere, Dimere oder andere kurzkettige Grundbausteine von Polymeren, sind.
